# EUROPEAN PATENT APPLICATION

(11) **EP 2 312 651 A1**
(43) Date of publication of application: **20.04.2011**
(21) Application number: 09804942.2
(22) Date of filing: 03.08.2009
(51) Int. Cl.: H01L 33/00, H01L 21/205, H01S 5/343

(54) **GAN SEMICONDUCTOR OPTICAL ELEMENT, METHOD FOR MANUFACTURING GAN SEMICONDUCTOR OPTICAL ELEMENT, EPITAXIAL WAFER AND METHOD FOR GROWING GAN SEMICONDUCTOR FILM**

(30) Priority: 04.08.2008 JP 2008201039; 08.04.2009 JP 2009094335; 30.06.2009 JP 2009155208
(71) Applicant: Sumitomo Electric Industries, Ltd., Chuo-ku Osaka-shi Osaka 541-0041 (JP)
(72) Inventor: ENYA Yohei, Itami-shi Hyogo 664-0016 (JP); YOSHIZUMI Yusuke, Itami-shi Hyogo 664-0016 (JP); UENO Masaki, Itami-shi Hyogo 664-0016 (JP); AKITA Katsushi, Itami-shi Hyogo 664-0016 (JP); KYONO Takashi, Itami-shi Hyogo 664-0016 (JP); SUMITOMO Takamichi, Itami-shi Hyogo 664-0016 (JP); NAKAMURA Takao, Itami-shi Hyogo 664-0016 (JP)
(74) Representative: Grünecker, Kinkeldey, Stockmair & Schwanhäusser Anwaltssozietät
(86) International application number: PCT/JP2009/063744
(87) International publication number: WO 2010/016459

(57) **Abstract**

In a GaN based semiconductor optical device 11a, the primary surface 13a of the substrate 13 tilts at a tilting angle toward an m-axis direction of the first GaN based semiconductor with respect to a reference axis "Cx" extending in a direction of a c-axis of the first GaN based semiconductor, and the tilting angle is 63 degrees or more, and is less than 80 degrees. The GaN based semiconductor epitaxial region 15 is provided on the primary surface 13a. On the GaN based semiconductor epitaxial region 15, an active layer 17 is provided. The active layer 17 includes one semiconductor epitaxial layer 19. The semiconductor epitaxial layer 19 is composed of InGaN. The thickness direction of the semiconductor epitaxial layer 19 tilts with respect to the reference axis "Cx." The reference axis "Cx" extends in the direction of the [0001] axis. This structure provides the GaN based semiconductor optical device that can reduces decrease in light emission characteristics due to the indium segregation.

## Description

### Technical Field

The present invention relates to a GaN based semiconductor optical device, a method of fabricating a GaN based semiconductor optical device, an epitaxial wafer, and a method of growing a GaN based semiconductor film.

### Background Art

Patent Literature 1 discloses a light emitting diode. In the light emitting diode, an off angle of the substrate surface is in an angle of 30-50 degrees, 80-100 degrees, and 120-150 degrees. In these angle ranges, the sum of the internal electric fields, i.e., piezo electric field and spontaneous polarization, is close to zero. Non-Patent Literatures 1 to 3 disclose GaN based semiconductor light emitting diodes. The light emitting diode in Non-Patent Literature 1 is formed on a substrate having an off angle of 58 degrees. The light emitting diode in Non-Patent Literature 2 is formed on a substrate having an off angle of 62 degrees. The light emitting diode in Non-Patent Literature 3 is formed on the m-plane surface of a substrate. Non-Patent Literatures 4 and 5 disclose calculations of piezo electric fields.

### Citation List

### Patent Literature

[Patent Literature 1] USP 6849472

[Non Patent Literature 1] Japanese Journal of Applied Physics vol.45 No.26 (2006) pp.L659
[Non Patent Literature 2] Japanese Journal of Applied Physics vol.46 No.7 (2007) pp.L 129
[Non Patent Literature 3] Japanese Journal of Applied Physics vol.46 No.40 (2007) pp. L960
[Non Patent Literature 4] Japanese Journal of Applied Physics vol.39 (2000) pp.413
[Non Patent Literature 5] Journal of Applied Physics vol.91 No.12 (2002) pp.9904

### Summary of Invention

### Technical Problem

Available GaN based semiconductor optical devices are formed on c-plane GaN substrates. Recently, as shown in Non Patent Literature 3, GaN based semiconductor optical devices are formed on nonpolar planes (a-plane, m-plane) that are not different from the c-plane. Unlike the c-plane, the nonpolar planes exhibit small piezo electric field. Semi-polar planes, which are different from polar and nonpolar planes, are attractive in the fabrication of GaN based semiconductor optical devices, and are tilted with respect to the c-plane. The light emitting devices in Non Patent Literature 1 and Non Patent Literature 2 are formed on GaN substrates of specific off angles.

Patent Literature 1 discloses spontaneous polarization in addition to polarization that depends on crystal orientation, and chooses facet orientation such that the sum of piezo electric field and internal electric field in the light emitting layer becomes a small value near zero. Patent Literature 1 provides a solution to the internal field in the light emitting layer.

GaN based semiconductor optical devices can provide emission in wide range of wavelength. The light emitting layer is composed of a layer of GaN based semiconductor containing indium. The emission wavelength can be change by adjusting the indium composition of the light emitting layer. One of GaN based semiconductor layers may be, for example, InGaN. Since InGaN exhibits strong phase immiscibility, spontaneous fluctuation in the indium composition occurs in the growth, resulting in indium segregation. The indium segregation is also observed in not only InGaN but also other GaN based semiconductor containing indium. The indium segregation is frequently observed when increased indium composition is used in order to change its emission wavelength.

The threshold current of a semiconductor laser is increased by indium segregation in its emission layer. The indium segregation is one cause that reduces uniformity in light emission of the light emitting diode. Accordingly, what is desired is to reduce the indium segregation in GaN based semiconductor optical devices.

It is an object to provide a GaN based semiconductor optical device and an epitaxial wafer which has reduced deterioration of light emission characteristics due to the indium segregation and to provide a method of fabricating the GaN based semiconductor optical device. It is another object to provide a method of fabricating a GaN based semiconductor region that exhibits low indium segregation.

### Solution to Problem

One aspect of the present invention comprises: (a) a substrate composed of a first GaN based semiconductor, the substrate having a primary surface, the primary surface tilting at an angle toward an m-axis direction of the first GaN based semiconductor with respect to a plane perpendicular to a reference axis, the reference axis extending in a direction of a c-axis of the first GaN based semiconductor, the angle being 63 degrees or more, and the angle being less than 80 degrees; (b) a GaN based semiconductor epitaxial region provided on the primary surface; and (c) a semiconductor epitaxial layer for an active layer, the semiconductor epitaxial layer being provided on the GaN based semiconductor epitaxial region. The semiconductor epitaxial layer is composed of a second GaN based semiconductor, the second GaN based semiconductor comprises indium, and a c-axis of the semiconductor epitaxial layer tilts with respect to the reference axis. The reference axis is directed to one of [0001] and [000-1] axes of the first GaN based semiconductor.

In the GaN based semiconductor optical device, the surface of the substrate having the above tilting angle includes plural narrow terraces. Since the GaN based semiconductor epitaxial region is provided on this substrate, the crystal axis of the GaN based semiconductor epitaxial region is epitaxially-oriented to the crystal axis of the substrate. Accordingly, the surface of the GaN based semiconductor epitaxial region also tilts toward the m-axis with respect to a plane perpendicular to the reference axis Cx at an angle in a range of 63 degrees or more and less than 80 degrees. The surface of the GaN based epitaxial semiconductor region also includes plural narrow terraces. The arrangements of the terraces form micro-steps. The narrow terraces with the above angle range prevents the non-uniformity of indium composition over the micro-steps from occurring, thereby suppressing the deterioration of optical emission due to indium segregation. Since the structure of the terraces is associated with the tilting angle with respect to the c-axis, the deterioration of light emission is suppressed in both the substrate having a tilting angle with respect to the (0001) plane of the first GaN based semiconductor and the substrate having a tilting angle with respect to the (000-1) plane of the first GaN based semiconductor. In other words, when the reference axis extends in the direction of either [0001] or [000-1] axis of the first GaN based semiconductor, the deterioration of optical emission is suppressed.

In the present GaN based semiconductor optical device, it is preferable that the primary surface of the substrate tilt toward the m-axis of the first GaN based semiconductor at an angle of 70 degrees or more with respect to the plane perpendicular to the reference axis. In the present GaN based semiconductor optical device, the primary surface of the above angle range has terraces of much narrower width.

In the present GaN based semiconductor optical device, an off angle toward the a-axis of the first GaN based semiconductor is not zero, and the off angle is -3 degrees or more and +3 degrees or less. According to the present GaN based semiconductor optical device, the tilting toward the a-axis direction improves surface morphology of the epitaxial region. Further, in the present GaN based semiconductor optical device, preferably the primary surface of the substrate tilts toward the m-axis of the first GaN based semiconductor at an angle of 71 degrees to 79 degrees with respect to the plane perpendicular to the reference axis. According to the present GaN based semiconductor optical device, the tilt angle range of 71 degrees or more and 79 degrees or less strikes a balance between the step edge growth and the on-terrace growth.

The GaN based semiconductor optical device further comprises a second conductive type GaN based semiconductor layer. The GaN based semiconductor epitaxial region includes a first conductive type GaN based semiconductor layer. The active layer includes a well layer and a barrier layer arranged in a direction of a predetermined axis, and the well layer is composed of the semiconductor epitaxial layer and the barrier layer is composed of a GaN based semiconductor. The first conductive type GaN based semiconductor layer, the active layer and the second conductive type GaN based semiconductor layer are arranged in the predetermined axis, and the direction of the reference axis is different from the predetermined axis.

In the present GaN based semiconductor optical device, reduced indium segregation is achieved in not only a semiconductor epitaxial layer composed of a single layer film but also the active layer of a quantum well structure.

In the GaN based semiconductor optical device according to the present invention, it is preferable that the active layer is provided to emit light having a wavelength of 370 nanometers or more. In the indium composition of the active layer emitting light of a wavelength in a range of 370 nanometers or more, indium segregation is reduced. It is preferable that the active layer is provided to emit light having a wavelength of 650 nanometers or less. In the indium composition of the active layer that emits light of a wavelength in a range of 650 nanometers or more, the semiconductor epitaxial layer cannot be provided with a desired crystal quality because of its high indium composition.

In the GaN based semiconductor optical device according to the present invention, it is preferable that the active layer be provided to emit light having a wavelength of 480 nanometers or more. It is preferable that the active layer be provided to emit light having a wavelength of 600 nanometers or less. In the GaN based semiconductor optical device, the angle range of 63 degrees or more and less than 80 degrees is effective in the optical emission ranging from 480 nanometers to 600 nanometers.

In the GaN based semiconductor optical device according to the present invention, the primary surface of the substrate tilts in a range of -3 degrees to +3 degrees with respect to one of (20-21) and (20-2-1) planes.

The GaN based semiconductor optical device, the (20-21) and (20-2-1) planes tilt at an angle of 75 degrees with respect to the plane perpendicular to the reference axis. Excellent optical emission is obtained around this angle.

In the GaN based semiconductor optical device according to the present invention, the reference axis is directed to the [0001] axis. Alternately, in the GaN based semiconductor optical device according to the present invention, the reference axis is directed to the [000-1] axis.

In the GaN based semiconductor optical device according to the present invention, the substrate comprises In_{S}Al_{T}Ga_{1-S-T}N (0≤S≤1, 0≤T≤1, 0≤S+T<1). Further, in the GaN based semiconductor optical device according to the present invention, the substrate comprises GaN. In the GaN based semiconductor optical device, GaN is categorized into binary compound of GaN based semiconductor, and provides excellent crystal quality and the stable substrate surface.

In the GaN based semiconductor optical device according to the present invention, the primary surface of the substrate has surface morphology of plural micro-steps, and the plural micro-steps comprise at least m-plane and (10-11) plane. In the GaN based semiconductor optical device, the above constituent surfaces and the step edges have high indium incorporation.

Another aspect of the present invention is a method of fabricating a GaN based semiconductor optical device. The method comprises the steps of: (a) performing thermal treatment of a wafer, the wafer being composed of a first GaN based semiconductor, a primary surface of the wafer tilting at an angle toward an m-axis direction of the first GaN based semiconductor with respect to a plane perpendicular to a reference axis, the reference axis extending in a direction of a c-axis of the first GaN based semiconductor, the angle being 63 degrees or more, and the angle being less than 80 degrees; (b) growing a GaN based semiconductor epitaxial region for an active layer on the primary surface; (c) forming a semiconductor epitaxial layer on a primary surface of the GaN based semiconductor epitaxial region. The semiconductor epitaxial layer is composed of a second GaN based semiconductor, the second GaN based semiconductor comprises indium as a constituent element, and a c-axis of the semiconductor epitaxial layer tilts with respect to the reference axis. The reference axis is directed to one of [0001] and [000-1] axes of the first GaN based semiconductor.

In the GaN based semiconductor optical device, the surface of the substrate having the above tilt angle includes plural narrow terraces. Since the GaN based semiconductor epitaxial region is provided on the substrate, the crystal axis of the GaN based semiconductor epitaxial region is epitaxially-oriented to the crystal axis of the substrate. Accordingly, the primary surface of the GaN based semiconductor epitaxial region also tilts toward the m-axis with respect to a plane perpendicular to the reference axis Cx at an angle in a range of 63 degrees or more and less than 80 degrees. The primary surface of the GaN based epitaxial semiconductor region includes plural narrow terraces. The arrangement of the terraces forms micro-steps. The above terraces have narrow widths. The narrow terraces with the above angle range prevent indium atoms thereon from migrating, thereby reducing the occurrence of the non-uniformity of indium composition over the micro-steps, and suppressing the deterioration of optical emission due to indium segregation. Since the structure of the terraces is associated with the tilt angle with respect to the c-axis, the deterioration of optical emission is suppressed in both the substrate having a tilt angle defined by the (0001) plane of the first GaN based semiconductor and the substrate having a tilt angle defined by the (000-1) plane of the first GaN based semiconductor. In other words, when the reference axis points either [0001] or [000-1] axis of the first GaN based semiconductor, the deterioration of optical emission is suppressed.

In the present GaN based semiconductor optical device, the primary surface of the substrate tilts toward the m-axis direction of the first GaN based semiconductor at an angle of 70 degrees or more with respect to the plane perpendicular to the reference axis. According to the present method, the primary surface tilting at an angle in the above range has narrower steps. Further, in the present GaN based semiconductor optical device, preferably the primary surface of the substrate tilts toward the m-axis direction of the first GaN based semiconductor at an angle in a range of 71 degrees to 79 degrees with respect to the plane perpendicular to the reference axis. According to the present GaN based semiconductor optical device, the tilt angle range of 71 degrees or more and 79 degrees or less strikes a balance between the step edge growth and the on-terrace growth.

In the present method, the active layer includes a quantum well structure, the quantum well structure has a well layer and a barrier layer, and the well layer and the barrier layer are arranged in the direction of a predetermined axis. The semiconductor epitaxial layer includes the well layer, and the barrier layer is composed of a GaN based semiconductor. The method further can comprise the steps of: forming the barrier layer on the semiconductor epitaxial layer; and growing a second conductive type GaN based semiconductor layer on the active layer. The GaN based semiconductor epitaxial region includes a first conductive type GaN based semiconductor layer, and the first conductive type GaN based semiconductor layer, the active layer and the second conductive type GaN based semiconductor layer are arranged in the predetermined axis, and the direction of the reference axis is different from the predetermined axis.

The method can achieve reduced indium segregation in not only a semiconductor epitaxial layer composed of a single layer film but also the active layer of a quantum well structure.

In the method according to the present invention, an off angle toward the a-axis direction of the first GaN based semiconductor is not zero, and the off angle is -3 degrees or more and +3 degrees or less. In this method, the tilting toward the a-axis direction permits the growth of an epitaxial layer with an excellent surface morphology.

In the method according to the present invention, the primary surface of the substrate tilts in a range of -3 degrees to +3 degrees defined with respect to one of (20-21) and (20-2-1) planes.

In this method, the (20-21) and (20-2-1) planes tilt at an angle of 75.09 degrees with respect to the reference axis. An off angle around the above angle provides the present device with excellent optical characteristics.

In the method according to the present invention, the wafer comprises In_{S}Al_{T}Ga_{1-S-T}N (0≤S≤1, 0≤T≤1, 0≤S+T<1). Further, in the method according to the present invention, the wafer comprises GaN. In this method, GaN is categorized into binary compound of GaN based semiconductor, and provides excellent crystal quality and the stable substrate surface.

In the method according to the present invention, surface morphology of the primary surface of the wafer has plural micro-steps, and these micro-steps include at least m-plane and (10-11) plane. In the method, the above constituent planes and the step edges have high indium incorporation, thereby reducing indium segregation.

Yet another aspect of the present invention is directed to a method of fabricating an epitaxial wafer for a GaN based semiconductor optical device. The method comprises the steps of: (a) performing thermal treatment of a substrate, the substrate being composed of a first GaN based semiconductor, the substrate having a primary surface, the primary surface tilting at an angle toward an m-axis direction of the first GaN based semiconductor with respect to a plane perpendicular to a reference axis, the reference axis extending in a direction of a c-axis of the first GaN based semiconductor, the angle being 63 degrees or more, and the angle being less than 80 degrees; (b) growing a GaN based semiconductor epitaxial region on the primary surface; (c) forming a semiconductor epitaxial layer for an active layer on a primary surface of the GaN based semiconductor epitaxial region. The semiconductor epitaxial layer is composed of a second GaN based semiconductor, the second GaN based semiconductor comprises indium as a constituent element, and a c-axis of the semiconductor epitaxial layer tilts with respect to the reference axis. The reference axis is directed to one of [0001] and [000-1] axes of the first GaN based semiconductor.

In the method according to the present invention, the reference axis extending in the [000-1] direction of the first GaN based semiconductor, as already explained above, prevents the decrease in optical emission characteristics. The scribing is carried out along the front surface, and this scribing method provides excellent cleavage yield.

Still another aspect of the present invention is directed to a method of fabricating a GaN based semiconductor optical device. The comprises the steps of: (a) performing thermal treatment of a wafer, the wafer being composed of a first GaN based semiconductor; (b) growing a GaN based semiconductor epitaxial region on the primary surface of the wafer, the GaN based semiconductor epitaxial region comprising a first conductive type GaN based semiconductor layer; (c) growing a semiconductor epitaxial layer for an active layer on a primary surface of the GaN based semiconductor epitaxial region; (d) growing a second conductive type GaN based semiconductor layer on the active layer to form an epitaxial wafer; (e) after forming the epitaxial wafer, forming an anode electrode and a cathode electrode for the GaN based semiconductor optical device to form a semiconductor substrate; (f) scribing a backside of the substrate product in a direction of the m-axis of the first GaN based semiconductor, the backside being opposite to the primary surface; and (g) after scribing the substrate product, performing cleavage of the substrate product to form a cleavage plane. The substrate product includes a semiconductor laminate. The semiconductor laminate includes the GaN based semiconductor epitaxial region, the semiconductor epitaxial layer, and the second conductive type GaN based semiconductor layer. The semiconductor laminate is provided between the primary surface of the substrate and the primary surface of the wafer. The cleavage surface includes an a-plane. The wafer has a primary surface of (20-21) plane. The semiconductor epitaxial layer is composed of a second GaN based semiconductor, and the second GaN based semiconductor comprises indium as constituent. A c-axis of the second GaN based semiconductor tilts with respect to a reference axis, and the reference axis extends in a direction of a c-axis of the first GaN based semiconductor. The reference axis is directed to a [000-1] axis of the first GaN based semiconductor.

After growing the GaN based semiconductor epitaxial region on the primary surface of the (20-21) plane of the GaN wafer to fabricate the epitaxial wafer, the substrate product is formed from the epitaxial wafer. In the substrate product formed using the GaN wafer having the (20-21) plane, it is preferable to scribe the substrate product along the backside thereof (the backside of the wafer). This scribing is to scribe the substrate product along the (20-2-1) plane. The (20-2-1) plane of GaN is associated with Ga-plane, whereas the (20-21) plane of GaN corresponds to N-plane. The (20-2-1) plane is harder than the (20-21) plane in hardness. Scribing along the (20-2-1) plane of the wafer backside improves cleavage yield.

Yet another aspect of the present invention is directed to a method of fabricating a GaN based semiconductor optical device. The method comprises the steps of: (a) performing thermal treatment of a wafer, the wafer being composed of a first GaN based semiconductor; (b) growing a GaN based semiconductor epitaxial region on a primary surface of the wafer, the GaN based semiconductor epitaxial region comprising a first conductive type GaN based semiconductor layer; (c) growing a semiconductor epitaxial layer for an active layer on a primary surface of the GaN based semiconductor epitaxial region; (d) growing a second conductive type GaN based semiconductor layer on the active layer to form an epitaxial wafer; (e) after forming the epitaxial wafer, forming an anode electrode and a cathode electrode for the GaN based semiconductor optical device to form a semiconductor substrate; (f) scribing a primary surface of the substrate product in a direction of the m-axis of the first GaN based semiconductor; and (g) after scribing the primary surface, performing cleavage of the substrate product to form a cleavage plane. The substrate product includes a semiconductor laminate, the semiconductor laminate includes the GaN based semiconductor epitaxial region, the semiconductor epitaxial layer, and the second conductive type GaN based semiconductor layer. The semiconductor laminate is provided between the primary surface of the substrate and the primary surface of the wafer. The cleavage surface includes an a-plane. The wafer has a primary surface. The primary surface tilts at an angle toward an m-axis direction of the first GaN based semiconductor with respect to a plane perpendicular to a reference axis. The reference axis extends in a direction of a c-axis of the first GaN based semiconductor. The angle is 63 degrees or more, and the angle is less than 80 degrees. The semiconductor epitaxial layer is composed of a second GaN based semiconductor. The second GaN based semiconductor comprises indium as constituent, and a c-axis of the semiconductor epitaxial layer tilts with respect to the reference axis. A c-axis of the second GaN based semiconductor tilts with respect to the reference axis, and the reference axis is directed to a [000-1] axis of the first GaN based semiconductor.

In the epitaxial wafer, the surface of the substrate having the above tilt angle includes plural narrow terraces. Since the GaN based semiconductor epitaxial region is provided on the substrate, the crystal axis of the GaN based semiconductor epitaxial region is epitaxially-oriented to the crystal axis of the substrate. Accordingly, the primary surface of the GaN based semiconductor epitaxial region also tilts toward the m-axis direction at an angle in a range of 63 degrees or more and less than 80 degrees with respect to a plane perpendicular to the reference axis Cx that extends in the c-axis direction. The primary surface of the GaN based epitaxial semiconductor region includes plural narrow terraces. The arrangement of the terraces forms micro-steps. The narrow terraces with the above angle range prevents the non-uniformity of indium composition over the micro-steps from occurring, thereby suppressing the deterioration of optical emission due to indium segregation in the epitaxial wafer. Since the structure of the terraces is associated in the tilt angle with respect to the c-axis, the deterioration of optical emission is suppressed in both the substrate having a tilt angle with respect to the (0001) plane of the first GaN based semiconductor and the substrate having a tilt angle with respect to the (000-1) plane of the first GaN based semiconductor. In other words, when the reference axis points to either [0001] or [000-1] axis of the first GaN based semiconductor, the deterioration of optical emission is suppressed.

Still another aspect of the present invention is directed to a method of growing a GaN based semiconductor film. The method comprises the steps of: (a) forming a GaN based semiconductor region having a primary surface, the primary surface having plural micro-steps, the micro-steps including at least m-plane and (10-11) plane as constituent planes, and (b) growing a GaN based semiconductor region on the primary surface of the GaN based semiconductor region, the GaN based semiconductor region containing indium as constituent. The primary surface of the GaN based semiconductor region tilts at an angle toward an m-axis direction of the GaN based semiconductor region with respect to a plane perpendicular to a reference axis. The reference axis extends in a direction of a c-axis of the GaN based semiconductor region. The angle is 63 degrees or more, and the angle is less than 80 degrees.

The foregoing and other objects, features, and advantages of the present invention will become more readily apparent from the following detailed description of the preferred embodiments of the present invention with reference to the accompanying drawings.

### Advantageous Effects of Invention

As described above, the above aspects of the present invention provide a GaN based semiconductor optical device and an epitaxial wafer which has reduced deterioration of light emission characteristics due to the indium segregation. The above other aspect of the present invention provides a method of fabricating the GaN based semiconductor optical device. Yet another aspect of the present invention provides a method of forming a GaN based semiconductor region that exhibits low indium segregation.

### Brief description of Drawings

Fig. 1 is a schematic view showing the structure of a GaN based semiconductor optical device according to the present embodiment.
Fig. 2 is a schematic view showing the structure of a GaN based semiconductor optical device according to the present embodiment.

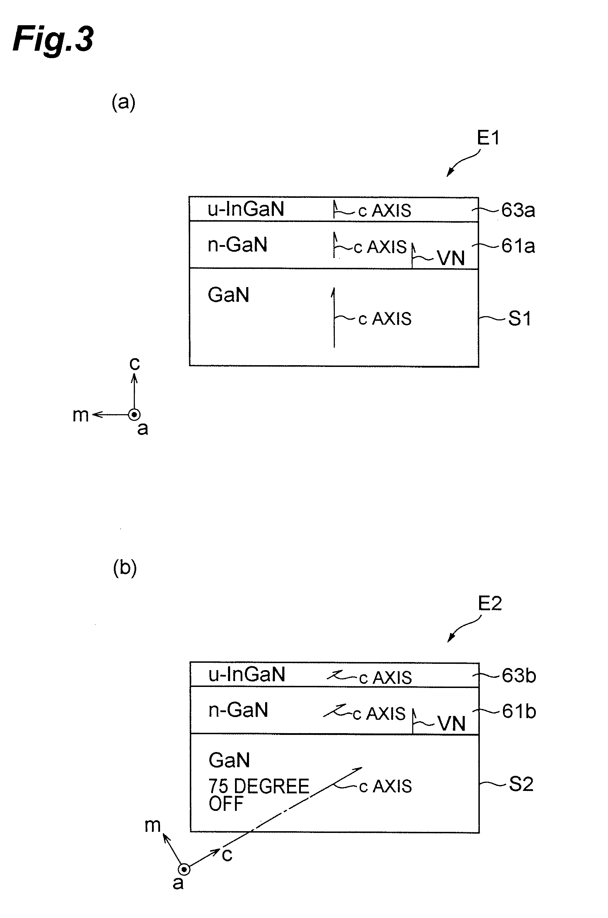

Fig. 3 is a schematic view showing epitaxial wafers E1 and E2 according to Example 1.
Fig. 4 is a graph of X-ray diffraction measurements and theoretical calculations.
Fig. 5 is a flow chart showing major steps in the method of fabricating a GaN based semiconductor optical device.
Fig. 6 is a schematic view showing light emitting diode structures (LED 1, LED 2) according to Example 2.
Fig. 7 is a graph showing electroluminescence spectra of the light emitting diode structures LED 1 and LED 2.
Fig. 8 is an illustration showing cathode luminescence (CL) images of the epitaxial wafers E3 and E4.
Fig. 9 is a graph showing measurements of the relationship between injection current and emission wavelength in the light emitting diode structures LED 1 and LED 2.
Fig. 10 is an illustration including graphs of calculations of piezo electric field.
Fig. 11 is a graph showing electroluminescence spectra of the light emitting diode structures each having a well layer of the indium composition different from each other.
Fig. 12 is an illustration showing luminosity curves of man and external quantum efficiency of an InGaN and AlGaInP well layers in light emitting diodes.
Fig. 13 is a schematic view showing a laser diode structure (LD1) according to Example 4.
Fig. 14 is a graph showing the relationship between variable off angles, which are defined with respect to the c-axis, of GaN primary surfaces toward the m-axis direction, and an indium composition of InGaN deposited on the GaN primary surfaces.
Fig. 15 is a schematic view showing deposition of GaN based semiconductor, which contains indium as constituent, onto GaN based semiconductor surfaces of c- and semi-polar planes with the angle β.
Fig. 16 is a schematic view showing a semiconductor laser according to Example 6.
Fig. 17 is a schematic view showing a semiconductor laser according to Example 7.
Fig. 18 is a schematic view showing a semiconductor laser according to Example 8.
Fig. 19 is a graph showing a photoluminescence (PL) spectrum PL₊₇₅ of a quantum well structure formed on an m-plane +75 degree off GaN substrate, and a PL spectrum PL₋₇₅ of a quantum well structure formed on an m-plane -75 degree off GaN substrate.
Fig. 20 is a flow chart showing major steps in the method of fabricating a semiconductor light emitting using a semi-polar substrate having a surface tilting at an acute angle with respect to (000-1).
Fig. 21 is a schematic view showing the major steps for cleavage of a semiconductor light emitting device using a semi-polar substrate having a surface tilting at an acute angle with respect to the (000-1) plane.
Fig. 22 is a schematic view showing growth modes in high and low temperatures.
Fig. 23 is an illustration showing AFM images of growth surfaces formed through step-flow-like growth and terrace growth.
Fig. 24 is a schematic view showing growth mechanism of step-flow-like growth of GaN and InGaN on a non-stable face at high temperature, and growth mechanism of step-edge growth and terrace growth of GaN and InGaN on a non-stable face at low temperature.
Fig. 25 is a graph showing the result of experiments for the growth of InGaN in the same growth recipe at the temperature of 760°C using GaN substrates having an off angle defined toward m-axis direction with respect to c-plane.
Fig. 26 is a schematic view showing the arrangement of surface atoms of {10-11} plane as an example.
Fig. 27 is a schematic view showing the arrangement of atoms at a surface tilting at an angle of 45 degrees toward the m-axis direction as an example.
Fig. 28 is a schematic view showing the growth surface having plural micro steps formed by {10-11} and m-planes.
Fig. 29 is a schematic view showing the arrangement of atoms at a surface tilting with respect to the c-plane at an angle of 75 degrees toward the m-axis direction as an example.
Fig. 30 is a graph showing the relationship between indium incorporation and off angles.
Fig. 31 is a table showing outlined off angle ranges and features of indium incorporation, indium segregation, and piezo electric field therein.
Fig. 32 is a table showing detailed off angle ranges and features of indium incorporation, indium segregation, and piezo electric field therein.

### Description of Embodiments

The teachings of the present invention will readily be understood in view of the following detailed description with reference to the accompanying drawings illustrated by way of example. Embodiments of a GaN based semiconductor optical device, a method of fabricating a GaN based semiconductor optical device, an epitaxial wafer, and a method of growing a GaN based semiconductor region will be explain below with reference to the accompanying drawings. When possible, parts identical to each other will be referred to with reference symbols identical to each other. The description of the present specification uses the following notation regarding a1-axis, a2-axis, a3-axis, and c-axis that indicate crystal axes of a hexagonal crystal structure: (for example "1") minus sign "-1" in front of figure is used in order to indicates reverse in axis direction, for example, the [000-1] axis is opposite to the [0001] axis.

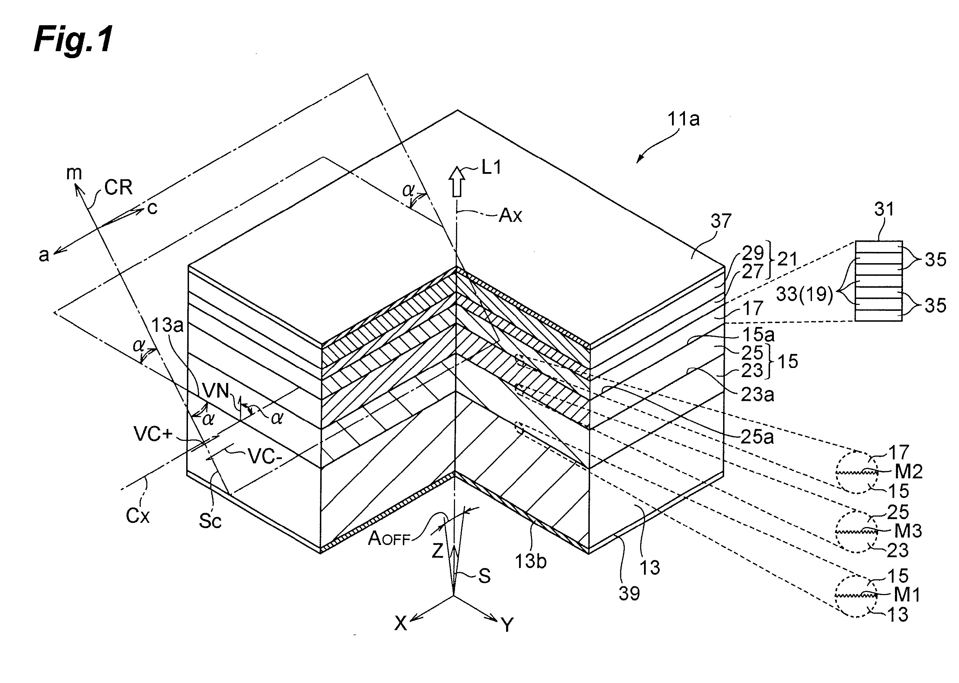

Fig. 1 is a view showing the structure of a GaN based semiconductor optical device according to the present embodiment. A GaN based semiconductor optical device 11 a encompasses, for example, a light emitting diode.

The GaN based semiconductor optical device 11a comprises a substrate 13, a GaN based semiconductor epitaxial region 15, and an active layer 17. The substrate 13 is composed of a first GaN based semiconductor, and the first GaN based semiconductor comprises GaN, InGaN or AlGaN. GaN is a binary compound of GaN based semiconductor, and can provide excellent crystal quality and stable substrate surface. The first GaN based semiconductor comprises, for example, AIN. The c-plane of the substrate 13 extends along a plane "Sc" shown in Fig. 1. A coordinate system CR (c-axis, a-axis, m-axis) is shown on the plane Sc for indicating crystal axes of a hexagonal GaN based semiconductor. The primary surface 13a of the substrate 13 tilts at a tilt angle toward an m-axis direction of the first GaN based semiconductor with respect to a reference axis "Cx" that extends in a direction of a c-axis of the first GaN based semiconductor, and the tilt angle is 63 degrees or more, and is less than 80 degrees. A tilting angle "α" is formed by the reference axis "Cx" and a normal axis "VN" of the primary surface 13a of the substrate 13. This angle "α" is equal to a angle formed by, for example, a vector "VC+" and the vector "VN." The GaN based semiconductor epitaxial region 15 is provided on the primary surface 13a. The GaN based semiconductor epitaxial region 15 includes one or more semiconductor layers. On the GaN based semiconductor epitaxial region 15, the active layer 17 is provided. The active layer 17 has at least one semiconductor epitaxial layer 19. The semiconductor epitaxial layer 19 is provided on the GaN based semiconductor epitaxial region 15. The semiconductor epitaxial layer 19 is composed of a second GaN based semiconductor containing indium, and the second GaN based semiconductor comprises InGaN and InAlGaN. The thickness direction of the semiconductor epitaxial layer 19 tilts with respect to the reference axis "Cx." The reference axis "Cx" extends in the direction of one of [0001] and [000-1] axes of the first GaN based semiconductor. In the present example, the reference axis "Cx" is directed to the direction of the vector "VC+," whereas the vector VC- points to the [000-1] axis.

In the GaN based semiconductor optical device 11 a, the surface 13a of the substrate 13 having the above tilt angle has a surface morphology M1 that includes plural narrow terraces as shown in Fig. 1. Since the GaN based semiconductor epitaxial region 15 is provided on the substrate 13, the crystal axis of the GaN based semiconductor epitaxial region 15 is epitaxially-oriented to the crystal axis of the substrate 13. Accordingly, the surface 15a of the GaN based semiconductor epitaxial region 15 also tilts toward the m-axis with respect to a plane perpendicular to the reference axis Cx at an angle in a range of 63 degrees or more and less than 80 degrees. The surface 15a of the GaN based epitaxial semiconductor region 15 has a surface morphology M2 that includes plural narrow terraces. The arrangement of the terraces forms micro-steps. The terraces with narrow width in the above angle range suppresses the non-uniformity of indium composition over the micro-steps from occurring, thereby preventing the deterioration of optical emission due to indium segregation.

Since the structure of the terrace is associated with the tilt angle with respect to the c-axis, the deterioration of optical emission is suppressed in both the substrate having a tilt angle with respect to the (0001) plane of the first GaN based semiconductor and the substrate having a tilting angle with respect to the (000-1) plane of the first GaN based semiconductor. In other words, when the reference axis points to either [0001] or [000-1] axis of the first GaN based semiconductor, the deterioration of optical emission is suppressed.

In the GaN based semiconductor optical device 11a, it is preferable that the surface 13a of the substrate 13 tilt at a tilt angle toward the m-axis direction with respect to the reference axis and that the tilt angle is 70 degrees or more and less than 80 degrees. The surface 13a of the above angle range has plural terraces with narrower widths.

The GaN based semiconductor optical device 11a suppresses decrease in optical emission characteristics of the active layer 17 due to indium segregation.

With reference to Fig. 1, the coordinate system "S" is shown. The surface 13a of the substrate 13 is directed to the z-axis direction, and extends in the directions of the x-axis direction and the y-axis direction. The x-axis direction points to the a-axis direction.

The GaN based semiconductor epitaxial region 15 includes one or more first conductive type GaN based semiconductor layer. In the present example, the GaN based semiconductor epitaxial region 15 includes an n-type GaN semiconductor layer 23 and an n-type InGaN semiconductor layer 25, which are arranged in the z-axis direction. Since the n-type GaN semiconductor layer 23 and the n-type GaN semiconductor layer 25 are epitaxially grown on the surface 13a of the substrate 13, the primary surface 23a of the n-type GaN semiconductor layer 23 and the primary surface 25a of the n-type GaN semiconductor layer 25 (equivalent to the surface 15a in this example) have surface morphologies M2 and M3 with terrace structures, respectively.

The surface morphologies M1, M2 and M3 have plural micro-steps which are arranged in the c-axis direction and extend in the direction that intersects with the tilt direction. The micro-steps have major constituent surfaces, which encompasses at least m-plane and (10-11) plane. These constituent surfaces and step edges of the micro-steps have excellent indium incorporation capability.

The GaN based semiconductor optical device 11a includes a GaN based semiconductor region 21 provided on the active layer 17. The GaN based semiconductor region 21 includes one or more second conductive type GaN based semiconductor layers. The GaN based semiconductor region 21 includes an electron blocking layer 27 and a contact layer 29, which are arranged in the z-axis direction. The electron blocking layer 27 can be composed of, for example, AlGaN, and the contact layer 29 can be composed of, for example, p-type GaN and p-type AlGaN.

In the GaN based semiconductor optical device 11 a, the active layer 17 is provided to emit light of the wavelength of 370 nanometers or more. The indium segregation can be reduced in the indium range applied to the active layer that emits light of the wavelength of 370 nanometers or more. The active layer 17 can be provided to emit light of the wavelength of 650 nanometers or less. Since the semiconductor epitaxial layer in the active layer that emits light of the wavelength of 650 nanometers or more has a large indium composition, it is not easy to obtain a semiconductor epitaxial layer with desired crystal quality.

The active layer 17 has a quantum well structure 31, and the quantum well structure 31 has a well layer(s) 33 and a barrier layer(s) 35, which are alternately arranged in the direction of the predetermined axis Ax. In the present example, the well layer 33 can be composed of the semiconductor epitaxial layer 19, and the well layer 33 comprises, for example, InGaN, InAlGaN. The barrier layer 35 can be composed of GaN based semiconductor, and the GaN based semiconductor comprises, for example, GaN, InGaN, and AlGaN. The n-type GaN semiconductor layer 23, the n-type InGaN semiconductor layer 25, the active layer 17, and GaN based semiconductor layers 27 and 29 are arranged in the direction of the predetermined axis "Ax." The direction of the reference axis "Cx" is different from the direction of the predetermined axis "Ax."

The GaN based semiconductor optical device 11a allows small indium segregation in the quantum well structure 31 as well as the semiconductor epitaxial layer composed of a single film.

The GaN based semiconductor optical device 11a includes a first electrode 37 (for example, anode) provided on the contact layer 29, and the first electrode 37 can include a transparent electrode that covers the contact layer 29. For example, Ni/Au can be used as the transparent electrode. The GaN based semiconductor optical device 11 a includes a second electrode 39 (for example, cathode) provided on the surface 13a of the substrate 13, and the second electrode 39 can comprise, for example, Ti/Al.

The active layer 17 emits light in response to the external voltage applied to the electrodes 37 and 39, and in the present example, GaN based semiconductor optical device 11a includes a surface emitting device. The active layer 17 has a small piezo electric field.

An off angle "A_{OFF}" formed toward the a-axis direction in the substrate 13 is not zero, and the off angle "A_{OFF}" formed toward the a-axis direction makes surface morphology of the epitaxial layer excellent. The off angle "A_{OFF}" is defined as an in-plane angle formed in the XY-plane. The off angle "A_{OFF}" is in the range of -3 degrees or more and +3 degrees or less. For example, it is preferable that the off angle "A_{OFF}" be -3 degrees or more and -0.1 degrees or less and +0.1 degrees or more and +3 degrees or less. Further, the off angle "A_{OFF}" ranging from -0.4 degrees to -0.1 degrees and from +0.1 degrees to +0.4 degrees makes the surface morphology more excellent.

In the GaN based semiconductor optical device 11a, it is preferable that the active layer 17 be provided to emit light of the wavelength of 480 nanometers or more, and it is also preferable that the active layer 17 be provided to emit light of the wavelength of 600 nanometers or less. The use of the off angle in the range of 63 degrees or more and less than 80 degrees is effective in emitting light of the wavelength of 480 nanometers or more and 600 nanometers or less. Long wavelength emission in the above wavelength range needs a well layer of a large indium composition, and accordingly, a plane having large indium segregation, such as c-plane, m-plane and (10-11) plane, deteriorates the emission performance. But, the present embodiment shows that the above angle range exhibiting small indium segregation can reduce the deterioration in the intensity of emission in the long wavelength region of 480 nanometers or more.

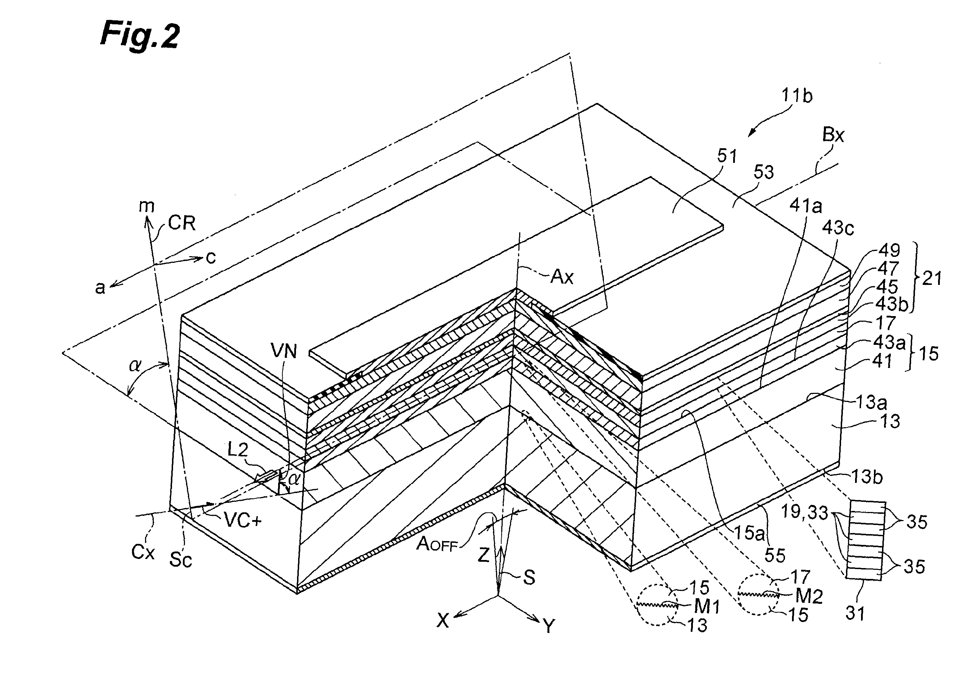

Fig. 2 is a schematic view showing the structure of a GaN based semiconductor optical device according to the present embodiment. A GaN based semiconductor optical device 11b encompasses, for example, a semiconductor laser. As is the case with the GaN based semiconductor optical device 11 a, the GaN based semiconductor optical device 11b comprises the substrate 13, the GaN based semiconductor epitaxial region 15, and the active layer 17. The c-plane extends along the plane Sc shown in Fig. 2. The coordinate system CR (a-axis, a-axis and m-axis) is depicted on the plane Sc. The surface 13a of the substrate 13 tilts toward the m-axis direction of the first GaN based semiconductor at an angle in the range of 63 degrees or more and less than 80 degrees with respect to the plane that is perpendicular to a reference axis "Cx" extending in the direction of the c-axis of the first GaN based semiconductor. The tilt angle α is defined as an angle formed by the normal vector "VN" and the reference axis "Cx." In this example, this angle is equal to an angle formed by the vector VC+ and vector VN. The GaN based semiconductor epitaxial region 15 is provided on the surface 13a. The active layer 17 includes a semiconductor epitaxial layer 19. The semiconductor epitaxial layer 19 is provided on the GaN based semiconductor epitaxial region 15. The semiconductor epitaxial layer 19 is composed of a second GaN based semiconductor, which contains indium as a constituent element. The thickness direction of the semiconductor epitaxial layer 19 tilts with respect to the reference axis "Cx." This axis "Cx" extends in the direction of the [0001] axis of the first GaN base semiconductor or the [000-1] axis of the first GaN base semiconductor. In the present example, the reference axis "Cx" is oriented to the direction of vector VC+, and the vector VC- is oriented the direction of the [000-1]. Fig. 2 also shows an off angle "A_{OFF}," and this off angle "A_{OFF}" is defined in the XZ-plane.

The GaN based semiconductor optical device 11b can provide the surface 13a of the substrate 13 with a surface morphology having plural terraces each of which is narrow as shown in Fig. 2. The GaN based semiconductor epitaxial region 15 is provided on the substrate 13. The crystal axis of the GaN based semiconductor epitaxial region 15 is epitaxially-oriented to the crystal axis of the substrate 13. Accordingly, the surface 15a of the GaN based semiconductor epitaxial region 15 also tilts toward the m-axis direction with respect to a plane perpendicular to the reference axis Cx at an angle in the range of 63 degrees or more and less than 80 degrees. The surface 15a of the GaN based epitaxial semiconductor region 15 has a surface morphology M2 that includes plural narrow terraces. The arrangement of these terraces forms micro-steps. The narrow terraces in the above angle range suppress the non-uniformity of indium composition over the micro-steps from occurring, thereby preventing the deterioration of optical emission due to indium segregation.

In an example of the GaN based semiconductor optical device 11b, the GaN based semiconductor epitaxial region 15 includes an n-type cladding layer 41 and an waveguiding layer 43a, which are arranged in the axis "Ax" (the z-axis direction). The n-type cladding layer 41 can be composed of, for example, AlGaN or GaN, and the waveguiding layer 43a can be composed of, for example, undoped InGaN. Since the n-type cladding layer 41 and waveguiding layer 43a are epitaxially grown on the surface 13a of the substrate 13, the surface 41a of the n-type cladding layer 41 and the surface 43c (equivalent to the surface 15a) of the waveguiding layer 43a also have surface morphologies of respective terrace structures. These surface morphologies have plural micro-steps arranged in the tilt direction of the c-axis, and extend in a direction intersecting with the tilt direction. The major constituent planes of the micro-steps have at least m-plane, (20-21) plane and (10-11) plane. The constituent planes and their step edges have increased indium incorporation.

In the GaN based semiconductor optical device 11b, the GaN based semiconductor region 21 includes an waveguiding layer 43b, an electron blocking layer 45, a cladding layer 47 and a contact layer 49, which are arranged in the z-axis direction. The waveguiding layer 43b can be composed of, for example, undoped InGaN. The electron blocking layer 45 can be composed of, for example, AlGaN, and the cladding layer 47 can be composed of, for example, p-type AlGaN or p-type GaN. The contact layer 49 can be composed of, for example, p-type AlGaN or p-type GaN.

The GaN based semiconductor optical device 11b includes a first electrode 51 (for example, anode) provided on the contact layer 49, and the first electrode 51 is connected to the contact layer 49 through a stripe window of an insulating film that covers the contact layer 49. For example, Ni/Au can be used for the first electrode 51. The GaN based semiconductor optical device 11b includes a second electrode 55 (for example, cathode) provided on the backside 13b of the substrate 13, and the second electrode 55 is composed of for example, Ti/Al.

The active layer 17 produces light in response to the application of external voltage through the electrodes 51 and 55, and in the present example, the GaN based semiconductor optical device 11b includes edge emitting device. In the active layer 17, the piezo electric field has a z-component (a component in the direction of the predetermined axis Ax) opposite to a direction from the p-type GaN based semiconductor layers 43a, 45, 47 and 49 to the n-type GaN based semiconductor layers 41 and the waveguiding layer 43a. In the GaN based semiconductor optical device 11b, since the piezo electric field has the z-component opposite to the direction of the electric field caused by the application of external voltage through the electrodes 51 and 55, the wavelength shift is reduced.

In the GaN based semiconductor optical devices 11a and GaN based semiconductor optical device 11b, the off angle "A_{OFF}" can be a non-zero value. The off angle "A_{OFF}" formed in the a-axis direction provides the epitaxial region with excellent surface morphology. The off angle "A_{OFF}" ranges from -3 degrees to + 3 degrees, and specifically may range from -3 degrees to -0.1 degrees or from +0.1 degrees to +3 degrees. Further, the off angle "A_{OFF}" ranging from -0.4 degrees to -0.1 degrees or from +0.1 degrees to +0.4 degrees makes the surface morphology more excellent.

In the GaN based semiconductor optical devices 11a and 11b, the active layer 17 can be formed to emit light of a wavelength equal to 480 nanometers or more, and the active layer 17 can be formed to emit light of a wavelength equal to 600 nanometers or less. The tilt angle that is 63 degrees or more and less than 80 degrees is effective in obtaining emission ranging from 480 nanometers to 600 nanometers. Emission in this wavelength range needs a large indium composition of well layers, and the c- and m-planes and the (10-11) plane that have a large segregation reduces the intensity of emission. But, the indium segregation is reduced in the above angle range, so that decrease in the emission intensity becomes reduced even in the long wavelength region of 480 nanometers or more. The thickness range of the well layer ranges from 0.5 nanometers to 10 nanometers, for example. The indium composition X of In_{X}Ga_{1-X}N ranges from 0.01 to 0.50, for example.

### (Example 1)

GaN wafers S 1 and S2 are prepared. The wafer S1 has the primary surface of the c-plane of hexagonal GaN. The wafer S2 has the primary surface which tilts at an angle of 75 degrees toward the m-axis direction of hexagonal GaN with respect to the c-plane, and this tilt surface is referred to as (20-21) plane. Both of the above surfaces are mirror-polished. Variation in the off angle ranges over the primary surface of the wafer S2 from -3 degrees to +3 degrees with respect to the (20-21) plane.

An Si-doped GaN layer and an undoped InGaN layer are epitaxially grown by metal organic chemical vapor deposition on the GaN wafers S 1 and S2 to form epitaxial wafers E1 and E2, respectively. Trimethyl-gallium (TMG), trimethyl-indium (TMI), ammonia (NH₃) and silane (SiH₄) are used as raw material for metal organic chemical vapor deposition.

The wafers S1 and S2 are loaded into a reactor. Epitaxial growth onto these wafers is carried out using the following recipes. Thermal treatment of the wafers is carried out at a temperature of 1050 °C and a pressure of 27 kPa for ten minutes while supplying NH₃ and H₂ to the reactor. This thermal treatment is carried out in a temperature range of 850°C to 1150°C. The atmosphere for the thermal treatment can be mixed gas, such as NH₃ and H₂. The thermal treatment modifies the surface of the wafer S2 to form a terrace structure specified by the off angle.

After the thermal treatment, TMG, NH₃ and SiH₄ are supplied to the reactor to grow Si-doped GaN layers 61a and 61b at a temperature of 1000°C. The Si-doped GaN layers 61a and 61b have a thickness of 2 micrometers, for example. Then, TMG, TMI, and NH₃ are supplied to the reactor to grow undoped InGaN layers 63a and 63b at a temperature of 750°C. The undoped InGaN layers 63a and 63b have a thickness of 20 nanometers, for example. The molar ratio, V/III, is set at 7322, and the reactor pressure is set at 100 kPa. After the film growth, the temperature of the reactor is decreased to room temperature to fabricate epitaxial wafers E1 and E2.

X-ray diffraction measurement of the epitaxial wafers E1 and E2 is carried out, and ω-2θ method is used for the scan. Since the diffraction angle is associated with the lattice constant of the crystal, the X-ray diffraction measurement provides the molar ratio of constituents of ternary mixed crystal, for example, InGaN.

Since the off angles of the primary surfaces of the epitaxial wafer E1 and E2 are different from each other, the alignment of an X-ray source assembly, a stage, and an X-ray detector is carried out with respect to the respective off angles of the epitaxial wafers in the X-ray diffraction measurement.

Specifically, the axis alignment of the epitaxial wafer E1 is carried out to the [0001] axis. Fitting theoretical calculations to the actual measurements is carried out to determine the indium composition of the InGaN. In this plane orientation, since the normal axis direction of the wafer primary surface, i.e. [0001], is the same as the direction of the axis alignment direction, i.e. [0001], the result values of the fitting theoretical calculation indicate the indium composition without correction.

The axis alignment of the epitaxial wafer E2 is carried out to the [10-10] axis. In this axis alignment, X-ray beam is incident to the wafer primary surface (20-21) at a tilt angle of 15 degrees, so that the resultant values obtained by X-ray diffraction measurement underestimate the indium composition. The correction of the measured values is needed depending on a tilt angle with respect to the direction of the [10-10] in fitting theoretical calculation. The correction allows the determination of the indium composition of InGaN.

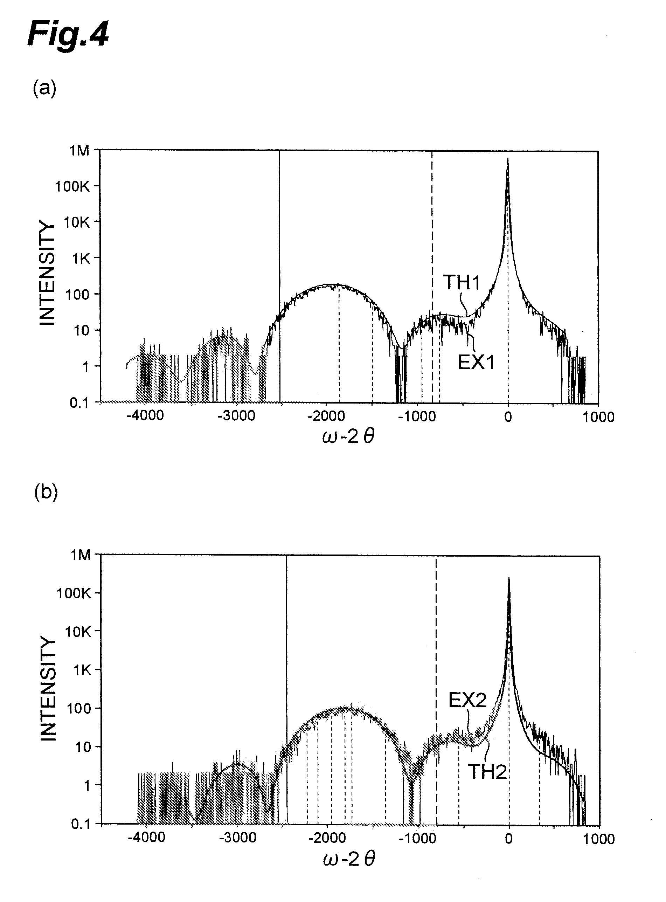

Fig. 4 shows graphs of the X-ray diffraction measurements and the fitting theoretical calculations. Referring to Part (a) of Fig. 4, the experimental result EX1 and the fitting curve TH1 are shown, whereas referring to Part (b) of Fig. 4, the experimental result EX2 and the fitting curve TH2 are also shown. The indium composition of the epitaxial wafer E1 is 20.5 percent, and the indium composition of the epitaxial wafer E2 is 19.6 percent. The experimental results reveal that indium incorporation of GaN (20-21) plane is equivalent to that of the c-plane. The indium incorporation of the GaN (20-21) plane can be preferably applied to long wavelength light emitting devices that require high indium composition in the fabrication of optical devices, such as, light emitting diodes and semiconductor laser diodes. This shows that InGaN with the same indium composition can be grown on the GaN (20-21) plane at a higher temperature, thereby improving the crystal quality of the light emitting layer.

### (Example 2)

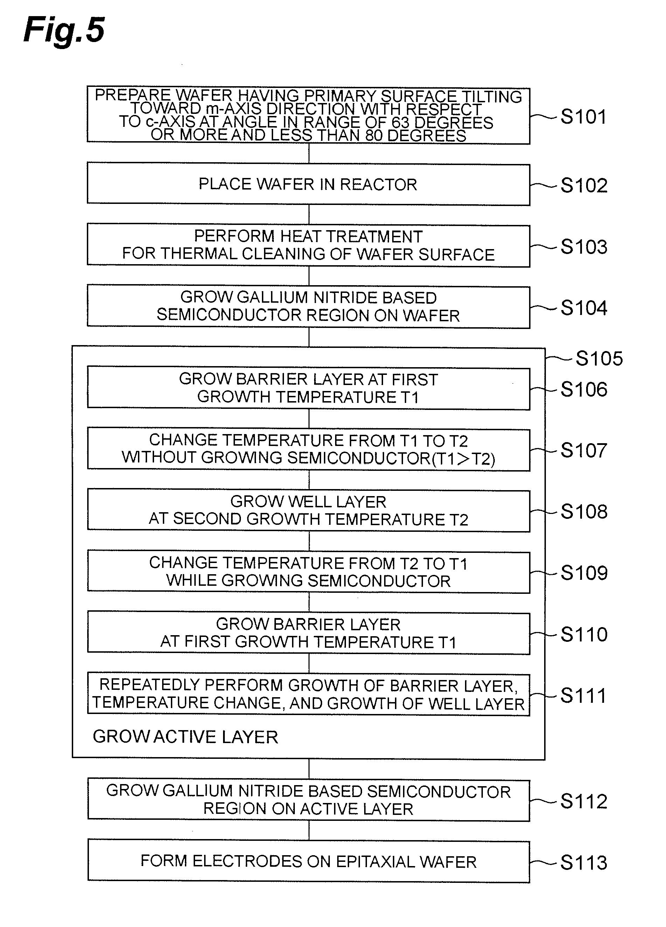

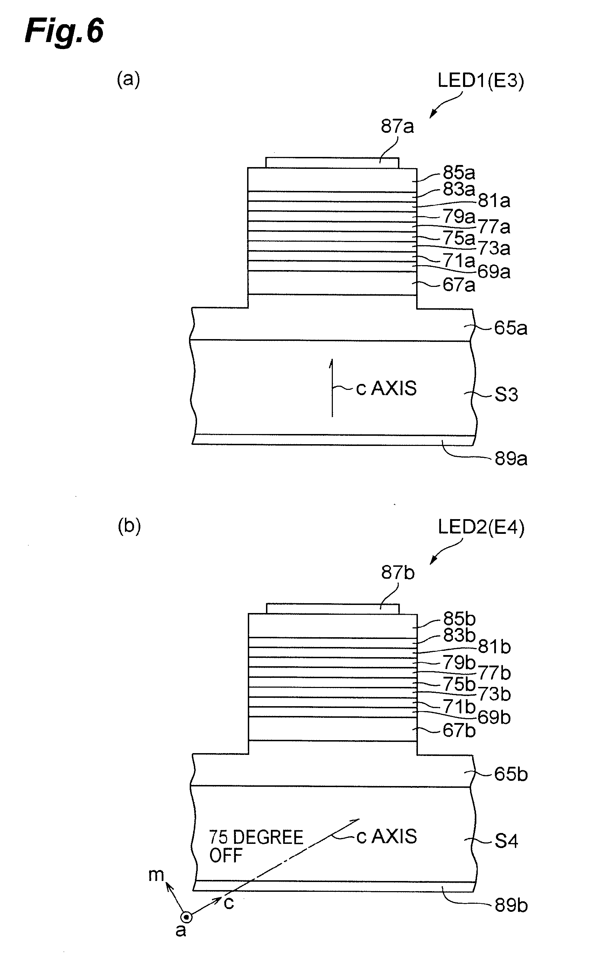

Epitaxial wafers for the light emitting diodes (LED1 and LED2) shown in Fig. 6 are formed on the GaN wafers S3 and S4 by metal organic chemical vapor deposition through the steps shown in Fig. 5. Trimethylgallium (TMG), trimethylindium (TMI), trimethylaluminum (TMA), ammonia (NH₃), silane (SiH₄) and bis(cyclopentadienyl)magnesium (Cp₂Mg) are used as raw material for epitaxial growth.

The GaN wafers E3 and E4 are prepared. The primary surface of the wafer S3 is made of the c-plane of hexagonal GaN. In step S101, the GaN wafer S4 is prepared, and the primary surface of the GaN wafer S4 has a tilt angle that is equal to or more than 63 degrees and less than 80 degrees. In the present example, the GaN wafer S4 has a primary surface that tilts at an angle of 75 degrees toward the m-axis direction of the hexagonal GaN with respect to the c-plane of the hexagonal GaN, and the relevant surface is referred to as (20-21) plane. These primary surfaces are mirror-polished.

Epitaxial growth onto the wafers S3 and S4 are carried out using the following recipes. In step S102, the wafers S3 and S4 are placed in the reactor. In step S103, thermal treatment of the wafers S3 and S4 is carried out at a temperature of 1050°C and a pressure of 27 kPa for ten minutes while supplying NH₃ and H₂ to the reactor. Surface modification by the thermal treatment forms a terrace structure in the surface of the wafer S4 depending on the tilt angle. After the thermal treatment, a GaN based semiconductor region is grown thereon in step S104. TMG, NH₃, and SiH₄ are supplied to the reactor to form a Si-doped GaN layer 65b at a temperature of 1000 °C. The thickness of the Si-doped GaN layer 65b is, for example, 2 micrometers. TMG, TMI, NH₃, and SiH₄ are supplied to the reactor to form a Si-doped InGaN layer 67b at a temperature of 850 °C. The thickness of the Si-doped InGaN layer 67b is, for example, 100 nanometers. The indium composition of the Si-doped InGaN layer 67b is, for example, 0.02.

An active layer is grown in step S105. TMG and NH₃ are supplied to the reactor to form an undoped GaN barrier layer 69b at a substrate temperature of 870°C, referred to as the growth temperature T1. The thickness of the undoped GaN barrier layer 69b is, for example, 15 nanometers. In step S107, after the growth, semiconductor growth is interrupted and the substrate temperature is changed from 870 °C to 760 °C. After the temperature change, TMG, TMI, and NH₃ are supplied to the reactor to form an undoped InGaN well layer 71 b at a substrate temperature T2 of 760°C. The thickness of the undoped InGaN well layer 71b is, for example, 3 nanometers. The indium composition of the InGaN well layer 71b is, for example, 0.25. The indium flow rate to form the InGaN well layer 71b can be chosen depending on the emitting wavelength. The supply of TMI is stopped to terminate the growth of the InGaN well layer 71 b. In step S109, TMG and NH₃ are supplied to the reactor. The substrate temperature is changed from 760 °C to 870 °C while TMG and NH₃ are supplied to the reactor. During this temperature change, a part of an undoped GaN barrier layer 73b is being formed. After the temperature change, the remaining of the undoped GaN barrier layer 73b is formed in S110. The thickness of the undoped GaN barrier layer 73b is 15 nanometers. In step S111, the growth of the barrier layer, the temperature change, and the growth of the well layer are repeatedly carried out to form InGaN well layers (75b, 79b) and GaN barrier layers (77b,81b).

In step 112, a GaN based semiconductor region is grown thereon. For example, the supply of TMG is stopped after growing the GaN barrier layer 81b, and the substrate temperature is increased to 1000°C. At this temperature, TMG, TMA, NH₃, and Cp₂Mg are supplied to the reactor to form a p-type Al_{0.18}Ga_{0.82}N electron blocking layer 83b. The p-type electron blocking layer 83b has a thickness of, for example, 20 nanometers. After this growth, the supply of TMA is stopped to grow a p-type GaN contact layer 85b. The thickness of the p-type GaN contact layer 85b is, for example, 50 nanometers. After the film growth, the reactor temperature is decreased to room temperature to obtain the epitaxial wafer E4. The growth temperature of the p-type region in the present example is lower than a temperature appropriate for the growth of a p-type region on the c-plane by a temperature of about 100 degrees. Experiments conducted by the inventors reveal that the active layer grown on a substrate having an angle in the off angle range in the present embodiment is sensitive to temperature rising in growing p-type layer and is easily deteriorated thereby and that the growth of a p-type layer at a temperature appropriate to the c-plane growth produces dark macro-regions, particularly, in the active layer for long wavelength emission. These dark macro-regions can be observed through a fluorescence microscope as non-luminous regions. Lowering the temperature for growing a p-type region prevents enlargement of the dark regions due to the high temperature for growing the p-type region.

Next, the wafer S3 is formed in the same process condition, i.e., a Si-doped GaN layer 65a (thickness: 2 micrometers), a Si-doped InGaN layer 67a (thickness: 100 nanometers), a p-type AlGaN electron blocking layer 83a (thickness: 20 nanometers) and a p-type GaN contact layer 85a (thickness: 50 nanometers). The active layer includes well layers (thickness: 3 nanometers) 71a, 75a, 79a, and GaN barrier layers (thickness: 15 nanometers) 69a, 73a, 77a, 81a. After growing the contact layer, the temperature of the reactor is decreased to room temperature to obtain the epitaxial wafer E3.

In step 113, electrodes are formed on the epitaxial wafers E3 and E4 as follows. First, mesa structures are formed by etching (for example, RIE). The mesa structures have a size of 400 micrometer squares. Next, p-side transparent electrodes (Ni/Au) 87a and 87b are formed on the p-type contact layers 85a and 85b, respectively. After that, p-pad electrodes are formed thereon. N-side electrodes (Ti/Al) 89a and 89b are formed on the wafer S3 and S4, respectively. Annealing for alloying electrodes is carried out (for example, at 550°C for ten minutes). The light emitting diodes structures LED 1 and LED2 are obtained through the above steps.

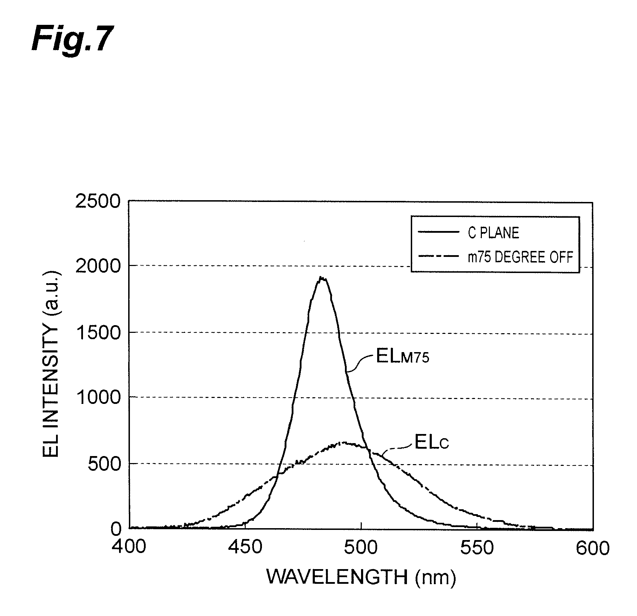

Current is applied to the light emitting diodes structures LED1 and LED2 to measure their electroluminescence spectra. The electrodes have a size of 500 micrometer squares, and the applied current is 120 mA. Fig. 7 shows electroluminescence spectra of the light emitting diodes structures LED 1 and LED2, and electroluminescence curves EL_{C} and EL_{M75} are shown therein. These electroluminescence spectra have approximately the same peak wavelength values. The peak intensity of spectrum EL_{M75} is more than twice the peak intensity of spectrum EL_{C}, and the full width at half maximum of spectrum EL_{M75} is less than half the full width at half maximum of spectrum EL_{C}. The optical intensity of the light emitting diode structure LED2 is high, and the full width at half maximum is small. These diodes have excellent chromatic purity, thereby improving color rendering properties in mixing of other colors. The full width at half maximum of the emission in the LED mode operation is narrow, which is effective in lowering the threshold current of laser diodes.

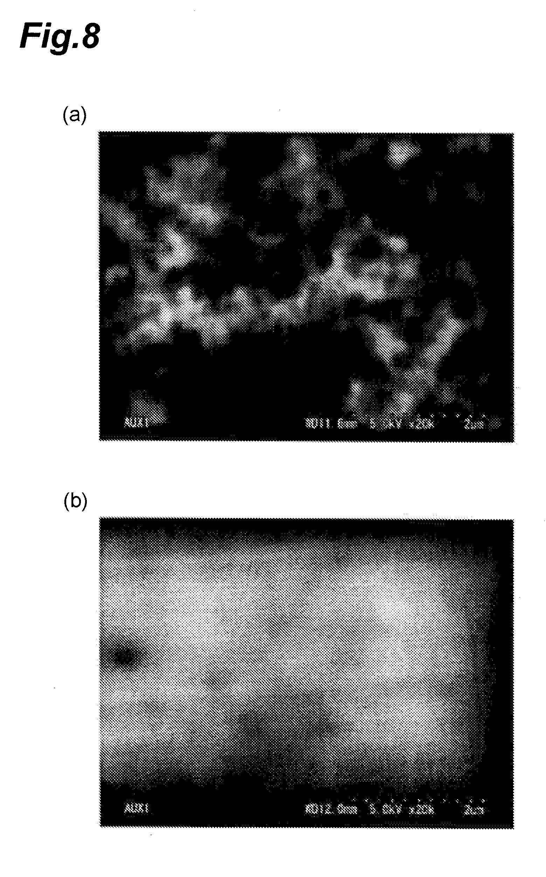

Fig. 8 shows cathode luminescence (CL) images of the epitaxial wafers E3 and E4. Referring to Part (a) of Fig. 8, the cathode luminescence image of the epitaxial wafer E3 is shown. The image exhibits non-uniform emission, and dark regions that do not contribute to optical emission are large in area. The non-uniform emission may be caused by indium segregation in the active layer of the epitaxial wafer E3. In the epitaxial wafer formed using the c-plane substrate, non-uniformity in optical emission worsen as the wavelength of the optical emission is increased. Accordingly, the optical intensity is reduced and the full width at half maximum is broadened as the emission wavelength is increased.

Referring to Part (b) of Fig. 8, the cathode luminescence image of the epitaxial wafer E4 is shown. The image in Part (b) of Fig. 8 has a more uniform emission than the image in Part (a) of Fig. 8, which shows that the indium segregation of the InGaN layer in the epitaxial wafer E4 is small. Accordingly, the emission intensity of light emitting device is strong, and the full width at half maximum is also narrow. In the light emitting device formed on the wafer S4, the reduction in the optical intensity is small in a longer wavelength emission, and the increase in the full width at half maximum is also small in the longer wavelength emission.

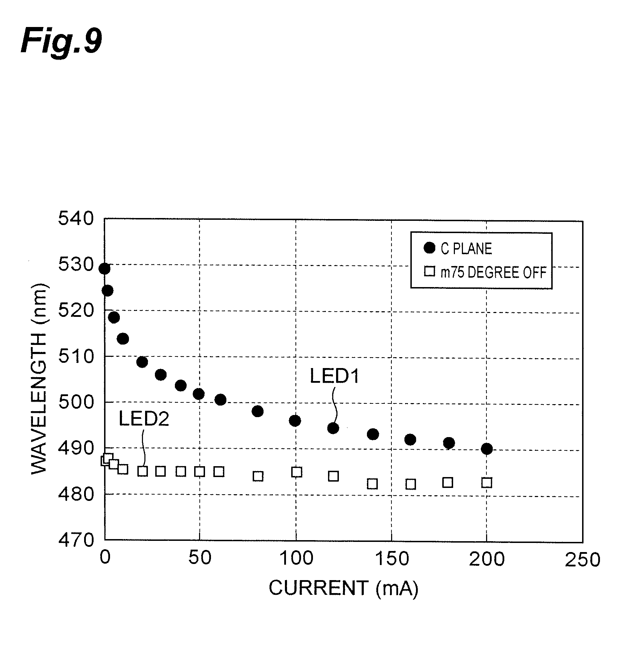

Fig. 9 is a graph showing measurements of emission wavelength and injection current in the light emitting diodes LED1 and LED2. With reference to Fig. 9, in the light emitting diode LED1, increasing the injection current causes gradual blue-shift of the emission wavelength, whereas in the light emitting diode LED2, a small amount of injection current initially causes a small blue-shift of the emission wavelength, and after the small blue-shift, further current injection causes substantially no blue-shift of the emission wavelength. This observation reveals that there is little change in the emission wavelength when current injected to the light emitting diode is increased to enhance the optical intensity. That is, this light emitting diode structure LED 2 has a small dependency of the emission wavelength on the injection current in the LED mode.

The emission measurements by optical pumping show that the emission wavelength of the light emitting structure (c-plane) LED1 is 535 nanometers and that the emission wavelength of the light emitting structure (75 degrees off) LED2 is 500 nanometers. The internal state of the light emitting diode that is optically pumped is equivalent to the internal state of the light emitting diode into which a small amount of current is injected.

The dependence of the emission wavelength on injected current and the measurements of optical emission caused by optical pumping show that the light emitting diode LED2 has wavelength shift characteristics as follows: when applied voltage is gradually increased, wavelength shift is substantially completed soon in very small emission ("before observable emission" in practical view) and the wavelength shift is not observed after the light emitting diode LED2 produces observable emission.

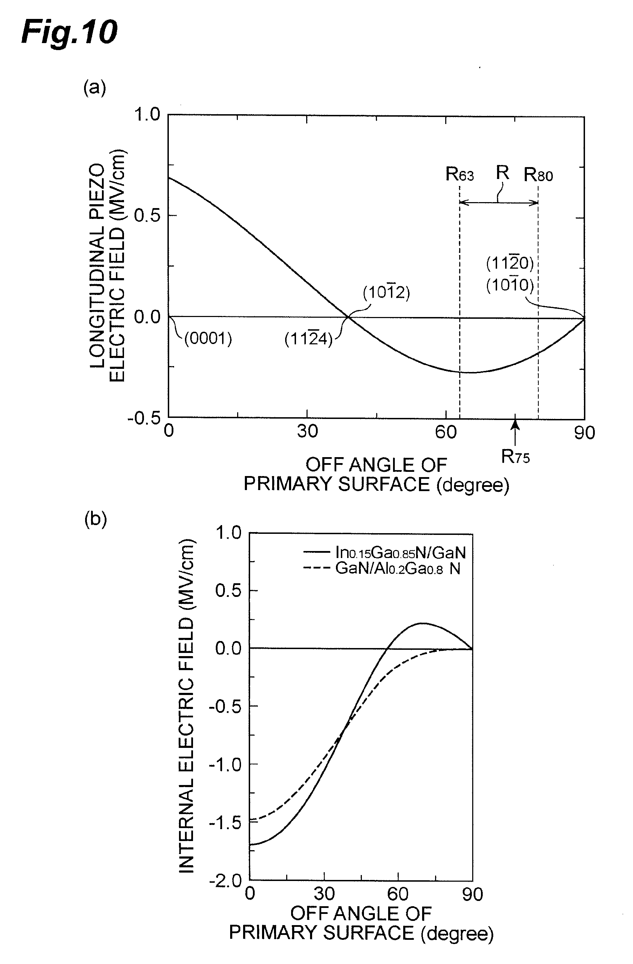

Piezo electric field in the active layer on the c-plane is larger than that in the active layer on the surface of the GaN based semiconductor that tilts at an angle in the range of 63 degrees or more and less than 80 degrees toward the m-axis direction of the GaN based semiconductor with respect to the c-plane. The direction of the piezo electric field in the light emitting diode LED2 is opposite to the direction of the piezo electric field in the light emitting diode LED1. The direction of electric field in current injection is opposite to the direction of the piezo electric field in the light emitting diode LED2. Fig. 10 shows calculations disclosed in Non Patent Literatures 4 and 5. Directions of the electric fields shown in Parts (a) and (b) of Fig. 10 are different from each other, and this difference comes from the definition of their electric fields. The gradient and curvature of the curves in Parts (a) and (b) of Fig. 10 are different from each other, and this difference comes from the parameters for the theoretical calculations.

### (Example 3)

Light emitting diode structures LED3 and LED4 are fabricated on wafers S5 and S6 each having a primary surface that tilts toward the m-axis direction at an angle of 75 degrees with respect to the c-plane. Emission wavelength of the light emitting diode structures LED3 and LED4 are different from each other. The emission wavelength of the light emitting diode structures LED3 and LED4 depends on the indium compositions of the light emitting structures LED3 and LED4, respectively. In order to change the indium compositions, the flow rate of indium raw material (for example, TMI) can be adjusted. Except the structure of the active layers in the light emitting diode structures LED3 and LED4, the formation of the light emitting diode structures LED3 and LED4 are the same as that of the light emitting diode structure LED2.

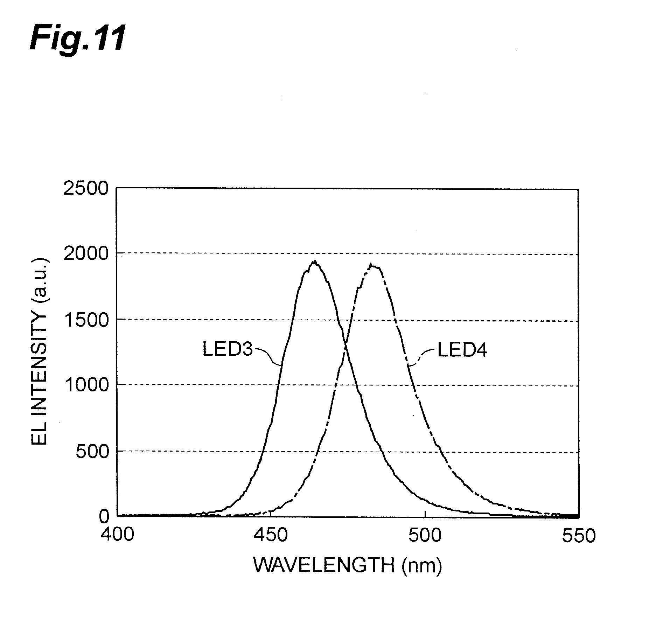

Fig. 11 is a graph showing electroluminescence spectra of the light emitting diode structures having the well layers, and the indium compositions are different from each other, . The well layer of the light emitting diode structure LED3 is composed of, for example, In_{0.16}Ga_{0.84}N, and the well layer of the light emitting diode structure LED4 is composed of, for example, In_{0.20}Ga_{0.80}N. The comparison between the light emitting structure LED3 (peak wavelength: 460 nanometers) and the light emitting structure LED4 (peak wavelength: 482 nanometers) reveals that the differences in the emission intensity and the full width at half maximum are not observed. This is very useful for fabricating high power and long wavelength light emitting devices.

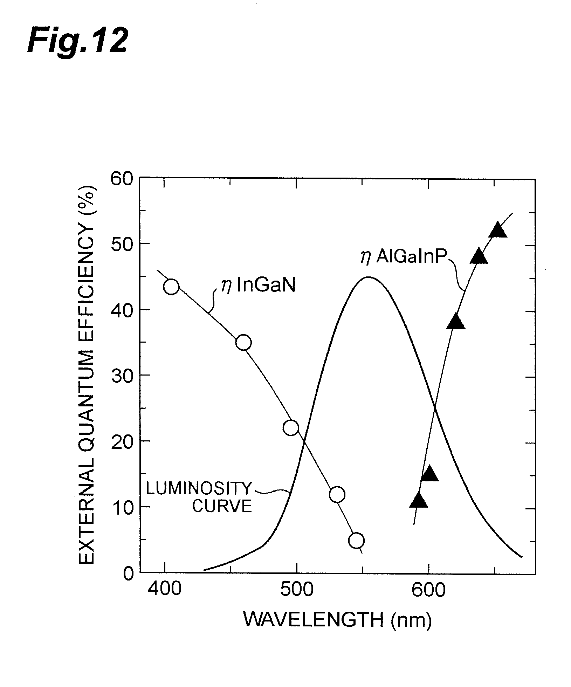

Fig. 12 is a graph showing luminosity curves of man and external quantum efficiency of InGaN and AlGaInP well layers in light emitting diodes. In order to obtain a light emitting diode structure that emitting light of a long wavelength, a well layer having high indium composition is formed. The inventors' knowledge is as follows: in the light emitting diode formed on the c-plane substrate, crystal quality of the InGaN well layer becomes reduced as the indium composition of the InGaN well layer increases. The reduction in the crystal quality decreases the emission intensity, and broadens the full width at half maximum. Accordingly, a light emitting device, such as a light emitting diode, with high external quantum efficiency cannot be provided in a longer wavelength region, particularly, that is longer than 500 nanometers.

As described above, the light emitting devices each includes a GaN based semiconductor well layer that contains indium as a constituent element. The GaN based semiconductor well layer is grown on the surface of GaN based semiconductor that tilts toward the m-axis direction of the GaN based semiconductor with respect to the c-plane at an angle which is equal to or more than 63 degrees and less than 80 degrees. The difference in the emission intensity and the full width at half maximum are not observed in the devices. This is very useful for fabricating high power and long wavelength light emitting devices.

### (Example 4)

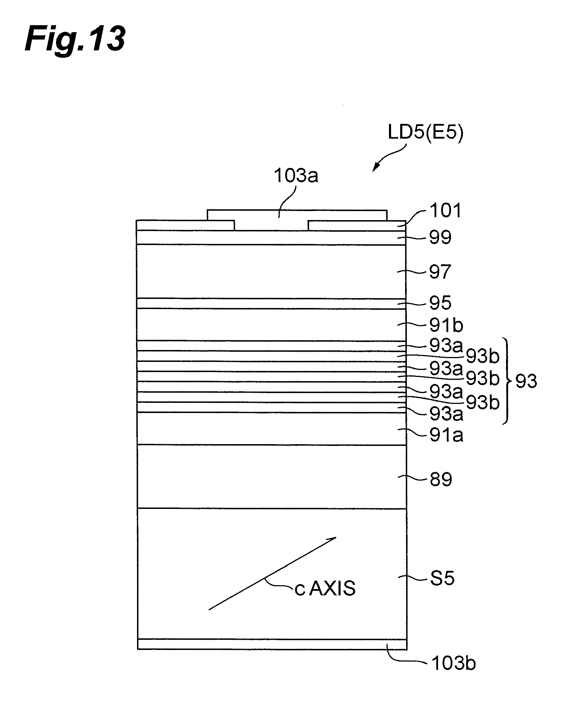

An epitaxial wafer for the laser diode structure (LD1) shown in Fig. 13 is formed on the GaN wafer S5 that has about the same quality as the wafer S4. Trimethylgallium (TMG), trimethylindium (TMI), trimethylaluminum (TMA), ammonia (NH₃), silane (SiH₄) and bis(cyclopentadienyl)magnesium (Cp₂Mg) are used as raw material for epitaxial growth.

The GaN wafer S5 is prepared, and the primary surface of the GaN wafer S5 has a tilt angle that is equal to or more than 63 degrees and less than 80 degrees. In the present example, the GaN wafer S5 has a primary surface that tilts at an angle of 75 degrees toward the m-axis direction of the hexagonal GaN with respect to the c-plane of the hexagonal GaN, and this tilt surface is referred to as (20-21) plane. The primary surface is also mirror-polished. Epitaxial growth onto the wafer S5 is carried out using the following recipes.

The wafer S5 is placed in the reactor. Thermal treatment of the wafer S5 is carried out at a temperature of 1050°C and a reactor pressure of 27 kPa for ten minutes while supplying NH₃ and H₂ to the reactor. Surface modification by the thermal treatment forms a terrace structure in the surface of the wafer S5 depending on the tilt angle. After the thermal treatment, a GaN based semiconductor region is grown thereon. TMG, TMA, NH₃, and SiH₄ are supplied to the reactor to form an n-type cladding layer 89 at a temperature of 1150 °C. The n-type cladding layer 89 is composed of, for example, Al_{0.04}Ga_{0.9}6N, and the thickness of the n-type cladding layer 89 is, for example, 2 micrometers.

TMG, TMI, and NH₃ are supplied to the reactor to form an waveguiding layer 91 a thereon. The waveguiding layer 91 a is, for example, an undoped In_{0.2}Ga_{0.98}N layer, and its thickness is, for example, 100 nanometers.

An active layer 93 is grown thereon. TMG and NH₃ are supplied to the reactor to form an undoped GaN based semiconductor barrier layer 93a at a substrate temperature of 870 °C, referred to as T1. The barrier layer 93a is made of, for example, GaN, and its thickness is, for example, 15 nanometers. After the growth of the barrier layer, semiconductor growth is interrupted and the substrate temperature is changed from 870 °C to 830 °C. After the temperature change, TMG, TMI, and NH₃ are supplied to the reactor to form an undoped InGaN well layer 93b at a substrate temperature of T2. The thickness of the undoped InGaN well layer 93b is, for example, 3 nanometers. The supply of TMI is stopped to terminate the growth of the InGaN well layer 93b. The substrate temperature is changed from 830 °C to 870 °C while TMG and NH₃ are supplied to the reactor. During the temperature change, a part of an undoped GaN barrier layer 93a is formed. After the temperature change, the remaining of the undoped GaN barrier layer 93a is formed. The thickness of the undoped GaN barrier layer 93a is 15 nanometers. The growth of the barrier layer, the temperature change, and the growth of the well layer are repeatedly carried out to form another InGaN well layer 93b and another GaN barrier layer 93a.

TMG, TMI, and NH₃ are supplied to the reactor to form an waveguiding layer 91b thereon at a temperature of 830 °C. The waveguiding layer 91b is, for example, an undoped In_{0.02}Ga_{0.98}N layer, and its thickness is, for example, 100 nanometers.

A GaN based semiconductor region is grown on the waveguiding layer 91b. For example, the supply of TMG and TMI is stopped after growing the waveguiding layer 91b, and the substrate temperature is increased to 1100°C. At this temperature, TMG, TMA, NH₃, and Cp₂Mg are supplied to the reactor to form an electron blocking layer 95 and a p-type cladding layer 97. The electron blocking layer 95 is, for example, Al_{0.12}Ga_{0.88}N, and the electron blocking layer 83b has a thickness of, for example, 20 nanometers. The p-type cladding layer 97 is, for example, A_{0.06}Ga_{0.94}N, and the cladding layer 97 has a thickness of, for example, 400 nanometers. After this growth, the supply of TMA is stopped and a p-type GaN contact layer 85b is grown. The thickness of the p-type GaN contact layer 85b is, for example, 50 nanometers. After this growth, the reactor temperature is decreased to room temperature to obtain the epitaxial wafer E5.

Electrodes are formed on the epitaxial wafer E5. First, an insulating film, such as silicon oxide, is deposited thereon, and a contact window is formed in the insulating film by photolithography and etching. The contact window has a stripe shape, and its width is, for example, 10 micrometers. A p-type electrode (Ni/Au) 103a is formed on the contact layer 99. After that, a p-pad electrode (Ti/Au) is formed thereon. An n-electrode (Ti/Al) 103b is formed on the backside of the wafer E5. After the above steps, annealing of electrodes for alloying (for example, 550°C and 10 minutes) is carried out to form a substrate product. After these steps, the substrate product is cleaved at 800 micrometer intervals to form a gain-guided structure laser diode LD1. The a-plane is used for cleavage planes. In an off substrate having a primary surface that tilts toward the m-axis direction, the m-plane also tilts, and the m-plane is not available for optical cavity.

The threshold current is 9 kAcm⁻². The lasing wavelength is 405 nanometers thereat. In this semiconductor laser, the full width at half maximum of the electroluminescence in the LED mode is small. Indium segregation in the InGaN well layer of the semiconductor laser is reduced. Since the optical emission in the LED mode is polarized in the XY plane in the direction perpendicular to the y-axis direction, the threshold current is greater than a semiconductor laser of a similar structure formed on the c-plane. The polarization in this direction increases the threshold current when the optical cavity is composed of a-planes and is oriented in the x-axis direction. The polarization degree is about 0.15.

Planes perpendicular to the y-axis direction shown in Figs. 1 and 2 is formed by dry etching (for example, reactive ion etching (RIE)) to form an optical cavity having these etched surfaces used as reflection planes. Since the optical cavity is oriented in the y-axis direction, a positive polarization degree in the LED mode is effective in decreasing the threshold current. The threshold current of the semiconductor laser is 5 kA/cm². Accordingly, the appropriate orientation of the optical cavity can reduce the threshold current.

### (Example 5)

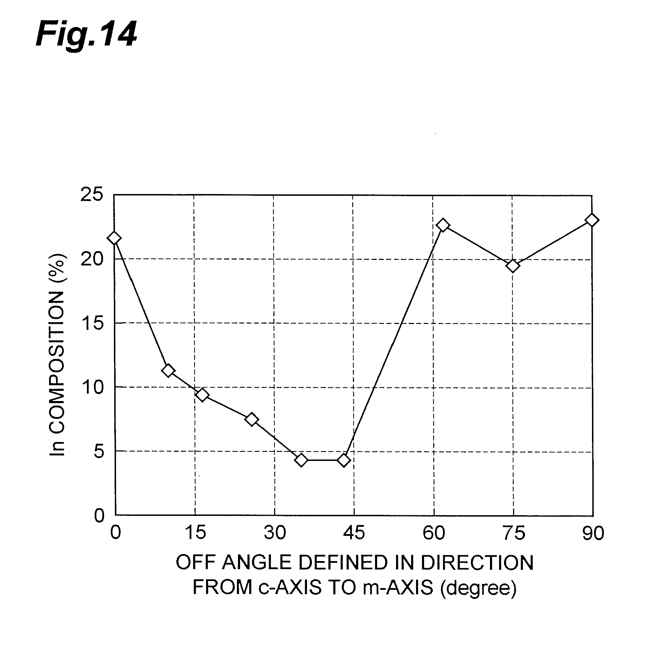

InGaN layers are formed on GaN wafers with various off angles, and the indium compositions of the InGaN layers are estimated. Fig. 14 is a graph showing the relationship between variable off angles, which are defined toward the m-axis direction with respect to the c-axis, of GaN primary surfaces and the indium compositions of InGaN deposited on the GaN primary surfaces. Off angles of the plots P1 to P4 are as follows;
Plot P1: 63 degrees;
Plot P2: 75 degrees;
Plot P3: 90 degrees (m-plane);
Plot P4: 43 degrees;
Plot P5: 0 degrees (c-plane).
Indium composition is monotonically decreased as the off angle increases in the range from plot P5 (c-plane) to plot P4. Plots P1 and P2 have indium incorporations that are equivalent to indium incorporation at plot P5. Plot P3 (m-plane) also has an excellent indium incorporation, but large indium segregation is observed in the range of an off angle equal to or more than 80 degrees, leading to the reduction of the optical intensity in a longer wavelength region.

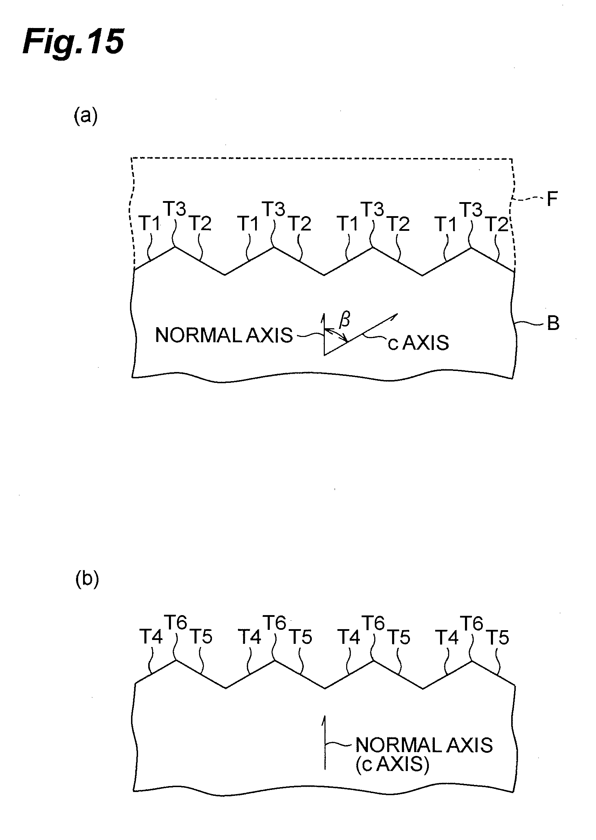

With reference to part (a) of Fig. 15, explanation is made on deposition of GaN based semiconductor, which contains indium, onto a GaN based semiconductor surface that tilts at an angle of β in the range of 63 degrees or more to less than 80 degrees. A semiconductor surface having an off angle in the above range, such as (20-21) plane, includes a terrace T1 of the (10-11) plane and a terrace of the m-plane. This semiconductor surface is composed of narrow steps including the terraces T1 and T2. The inventors' experiments reveal that the indium incorporation of the (10-11) plane in addition to the m-plane is equivalent to or greater than the indium incorporation of the c-plane. The width of the terrace sufficient to allow island-like growth of InN is required to enhance indium incorporation.

In the angle range of 10 degrees to 50 degrees, the semiconductor surface includes a terrace T4 of the (10-11) plane and a terrace T5 of the c-plane. This semiconductor surface is composed of narrow steps including the terraces T4 and T5. The widths of the terraces T4 and T5 become small in the above angle range as the off angle increases. Accordingly, the semiconductor surface having an off angle in the above range has small indium incorporation. When the semiconductor surface has steps of the c-plane and the (10-11) plane, indium atoms are incorporated on the terraces T4 and T5. But, from the point of view of chemical bond at the terrace edge (step edge) T6 formed by the terraces T4 and T5, indium atoms are not incorporated at the terrace edge T6.

The inventors' experiments reveal that the micro-steps structure of the terraces T1 and T2 has an excellent indium incorporation. Indium atoms are effectively incorporated at the terrace edge (step edge) T3 formed by the terraces T1 and T2, in addition to the terraces T1 and T2. This excellent indium incorporation can be confirmed by explanation based on the point of view of chemical bond at the terrace edge (step edge) T3. The incorporated indium atoms into the terrace edge T3 are not likely to be detached from the semiconductor surface in the step of heat treatment in ammonia atmosphere (the temperature rising step between the growth of the well layer and the growth of the barrier layer). Accordingly, for example, an amount of indium atoms desorbing from the surface of the well layer is small even if the well layer of InGaN grown at a temperature T1 is exposed to atmosphere in the reactor in the steps of temperature rising from the growth temperature T1 to the growth temperature T2 for the barrier layer.

A semiconductor surface of an off angle greater than 50 degrees, such as the (20-21) plane in the example, has an excellent indium incorporation. The image of emission from the active layer formed on the above semiconductor surface has an excellent uniformity. The full width at half maximum of the emission spectrum is narrow, and the optical intensity of the semiconductor device is also enhanced. The well layer with an increased indium composition that enables a long wavelength emission can reduce decrease in optical emission efficiency. The optical device and the method of fabricating the same are highly effective in achieving an optical device including an InGaN layer.

The method of growing a GaN based semiconductor film comprises the steps of: preparing a GaN based semiconductor region "B" having a primary surface with plural micro steps as shown in Part (a) of Fig. 15; and growing a GaN based semiconductor film "F," which contains indium as constituent, on the primary surface with plural micro steps. The plural micro steps include at least the m-plane and the (10-11) as major planes. Alternately, the method of growing a GaN based semiconductor film comprises the steps of: preparing a GaN based semiconductor region "B," having a primary surface, of GaN based semiconductor; and growing a GaN based semiconductor film "F," containing indium as constituent, on the primary surface of the GaN based semiconductor region "B." The primary surface of the GaN based semiconductor region "B" tilts toward the m-axis direction of the GaN based semiconductor with respect to the c-plane at an angle in the range of 63 degrees or more and less than 80 degrees.

The micro-step structure as an example is shown below. The height of the micro step structure is, for example, 0.3 nanometers, and, for example, 10 nanometers. The width of the micro step structure is, for example, 0.3 nanometers, and, for example, 500 nanometers. The density of the micro step structure is, for example, 2×10⁴ cm⁻¹ or more, and, for example, 3.3×10⁷ cm⁻¹ or less.

The reason why the off angle range of 63 degrees or more and less than 80 degrees provides small indium segregation is as follows. Indium atoms can migrate on wide terraces of stable planes, such as the c-plane, the m-plane (non-polar plane), and the (11-22) and (10-11) planes. Accordingly, indium atoms of a large atomic radius gather by migration, so that indium segregation takes place. As shown in Part (b) of Fig. 8, the cathode-luminescence image shows a non-uniform emission, whereas indium atoms incorporated in the terraces T1 and T2 cannot sufficiently migrate because the width of the terraces T1 and T2 is narrow in the angle range of 63 degrees or more and less than 80 degrees, such as the (20-21) plane. When indium atoms are incorporated at the terrace edges T3, the atoms cannot sufficiently migrate. Accordingly, indium atoms are incorporated into crystal at a position at which the atoms attach during semiconductor deposition. In this deposition, indium atoms attach in random order, leading to the cathode-luminescence image showing a uniform emission as shown in Part (a) of Fig. 8.

As shown in Fig. 14, the c-plane and the m-plane have increased indium incorporation, but have strong indium segregation, and particularly, an increased indium composition enhances indium segregation, thereby increasing the area of the non-luminous region that causes a non-uniform optical emission image. The increased indium composition in the active layer broadens the full width at half maximum of the emission spectrum. As shown in Fig. 14, an off angle ranging from the c-plane to the (10-11) plane exhibits reduced indium incorporation as compared with that of the c-plane. As shown in Fig. 14, an off angle ranging from the m-plane to the (10-11) plane exhibits increased indium incorporation as compared with that of the c-plane, and has low indium segregation.

As explained above, the off angle range of crystal orientation, typified by the (20-21) plane, has high indium incorporation and reduced indium segregation, which allows the growth of InGaN having an excellent crystal quality, and wide variation ranged of the indium composition associated with the emission wavelength, as compared with the angle range used conventionally. The optical device having an excellent performance can be fabricated.

The above description has been carried out with reference to the (20-21) plane, but the description is also applicable to the (20-2-1) plane. Crystal orientations and crystal planes, such as the (20-21) plane, the (10-11) plane and the m-plane, which are explained above, are not limited to the specified orientations and crystal planes by their notations, and encompass crystallographically equivalent orientations and planes. For example, the (20-21) plane indicates the following equivalent orientations and planes: the (02-21) plane; the (0-221) plane; (2-201 plane); (-2021) plane; and the (-2201) plane.

### (Example 6)

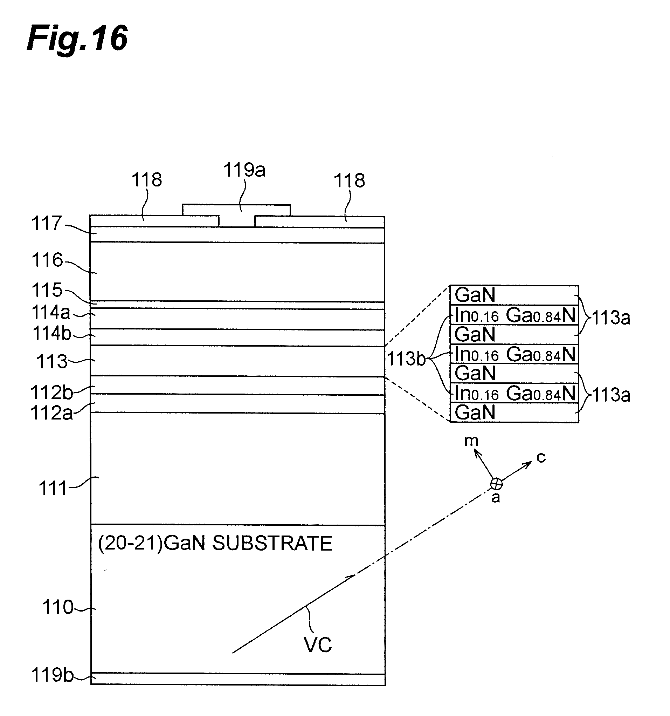

Fig. 16 is a schematic view showing a semiconductor laser according to the present example. The semiconductor laser shown in Fig. 16 is fabricated in the following manner. First, a GaN substrate 110 having a (20-21) plane is prepared. The following semiconductor layers are grown on the primary surface ((20-21) plane) of this GaN substrate.
N-type cladding layer 111: Si-doped AlGaN, growth temperature: 1150°C, thickness: 2 micrometers, aluminum composition: 0.04; Waveguiding layer 112a: undoped GaN, growth temperature: 840°C, thickness: 50 nanometers;
Waveguiding layer 112b: undoped InGaN, growth temperature: 840°C, thickness: 50 nanometers, indium composition: 0.01;
Active layer 113:
Barrier layer 113a: undoped GaN, growth temperature: 870°C, thickness: 15 nanometers;
Well layer 113b: undoped InGaN, growth temperature: 780°C, thickness: 3 nanometers;
Waveguiding layer 114b: undoped InGaN, growth temperature: 840°C, thickness: 50 nanometers, indium composition: 0.01;
Waveguiding layer 114a: undoped GaN, growth temperature: 840°C, thickness: 50 nanometers;
Electron blocking layer 115: Mg-doped AlGaN, growth temperature: 1000°C, thickness: 20 nanometers, aluminum composition: 0.12;
P-type cladding layer 116: Mg-doped AlGaN, growth temperature: 1000°C, thickness: 400 nanometers, aluminum composition: 0.06;
P-type contact layer 117: Mg-doped GaN, growth temperature: 1000°C, thickness: 50 nanometers.

An insulating layer 118, such as silicon oxide, is grown on the p-type contact layer 117, and a stripe window of 10 micrometer wide is formed using photolithography and wet-etching. A p-electrode (Ni/Au) 119a is formed and is contact with the p-type contact layer 117 through the stripe window, and then a pad electrode (Ti/Au) is formed thereon by evaporation. An n-electrode (Ni/Al) 119b is formed on the back side of the GaN substrate 110, and then a pad electrode (Ti/Au) is formed thereon by evaporation. These steps complete a substrate product, and the substrate product is cleaved at 800 micrometer intervals. Reflection multi-layers of SiO₂/TiO₂ are formed on the a-plane cleavage surfaces for an optical cavity to form a gain-guided structure laser diode. Reflectivity of the front surface is 80 percent, and reflectivity of the back surface is 95 percent.

The above laser diode has a lasing wavelength of 452 nanometers. Its threshold current is 12 kA/cm² and the operating voltage is 6.9 volts (at current of 960 mA).

### (Example 7)

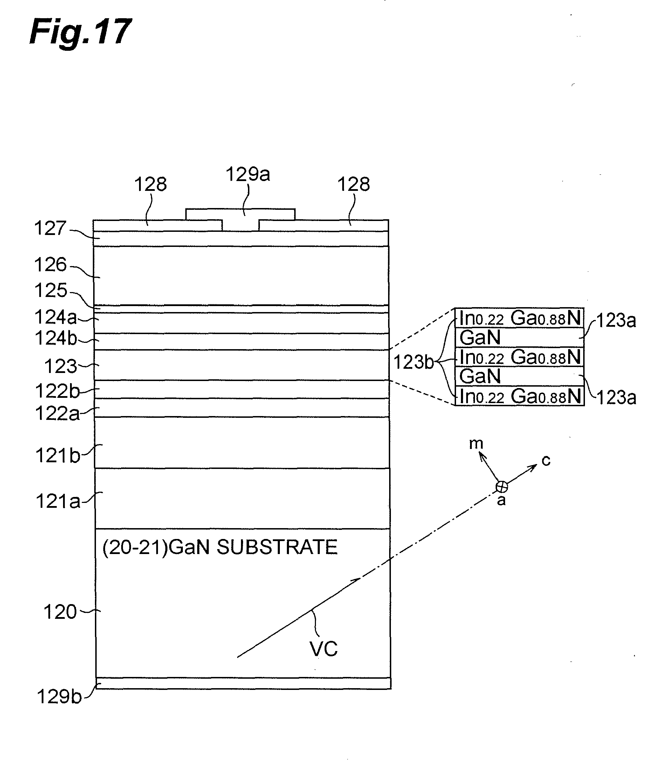

Fig. 17 is a schematic view showing a semiconductor laser according to the present example. The semiconductor laser shown in Fig. 17 is fabricated in the following manner. First, a GaN substrate 120 having a (20-21) plane is prepared. The following semiconductor layers are grown on the (20-21) primary surface of this GaN substrate.
N-type buffer layer 121a: Si-doped GaN, growth temperature: 1050°C, thickness: 1.5 micrometers;
N-type cladding layer 121b: Si-doped AlGaN, growth temperature: 1050°C, thickness: 500 nanometers, aluminum composition: 0.04;
Waveguiding layer 122a: undoped GaN, growth temperature: 840°C, thickness: 50 nanometers;
Waveguiding layer 122b: undoped InGaN, growth temperature: 840°C, thickness: 65 nanometers, indium composition: 0.03;
Active layer 123:
Barrier layer 123a: undoped GaN, growth temperature: 870°C, thickness: 15 nanometers;
Well layer 123b: undoped InGaN, growth temperature: 750°C, thickness: 3 nanometers, indium composition: 0.22;
Waveguiding layer 124b: undoped InGaN, growth temperature: 840°C, thickness: 65 nanometers, indium composition: 0.03;
Waveguiding layer 124a: undoped GaN, growth temperature: 840°C, thickness: 50 nanometers;
Electron blocking layer 125: Mg-doped AlGaN, growth temperature: 1000°C, thickness: 20 nanometers, aluminum composition: 0.12;
P-type cladding layer 126: Mg-doped AlGaN, growth temperature: 1000°C, thickness: 400 nanometers, aluminum composition: 0.06;
P-type contact layer 127: Mg-doped GaN, growth temperature: 1000°C, thickness: 50 nanometers.

An insulating layer 128, such as silicon oxide, is grown on the p-type contact layer 127, and a stripe window of 10 micrometer wide is formed using photolithography and wet-etching. A p-electrode (Ni/Au) 129a is formed and is contact with the p-type contact layer 127 through the stripe window, and then a pad electrode (Ti/Au) is formed thereon by evaporation. An n-electrode (Ni/Al) 129b is formed on the back side of the GaN substrate 120, and then a pad electrode (Ti/Au) is formed thereon by evaporation. These steps complete a substrate product, and the substrate product is cleaved at 800 micrometer intervals to form a-plane cleavage surfaces. Reflection multi-layers of SiO₂/TiO₂ are formed on the a-plane cleavage surfaces for an optical cavity to form a gain-guided structure laser diode. Reflectivity of the front surface is 80 percent, and reflectivity of the back surface is 95 percent.

The above laser diode has a lasing wavelength of 520 nanometers. Its threshold current is 20 kA/cm² and the operating voltage is 7.2 volts (at current of 1600 mA).

### (Example 8)

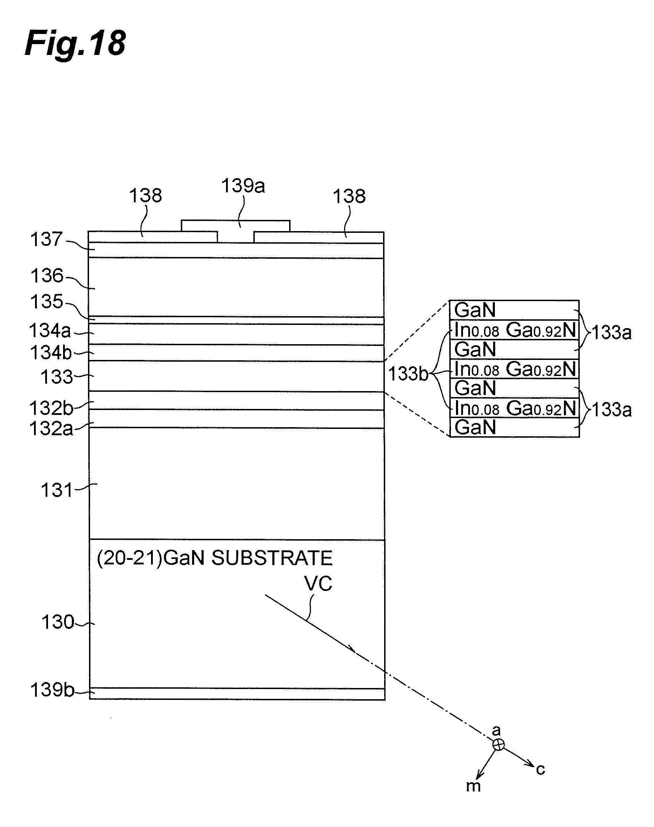

Fig. 18 is a schematic view showing a semiconductor laser according to the present example. The semiconductor laser shown in Fig. 18 is fabricated in the following manner. First, a GaN substrate 130 having a (20-2-1) plane is prepared. The following semiconductor layers are grown on the primary surface ((20-2-1) plane) of the GaN substrate: N-type cladding layer 131: Si-doped AlGaN, growth temperature: 1050°C, thickness: 2 micrometers, aluminum composition: 0.04;
Waveguiding layer 132a: undoped GaN, growth temperature: 840°C, thickness: 50 nanometers;
Waveguiding layer 132b: undoped InGaN, growth temperature: 840°C, thickness: 50 nanometers, indium composition: 0.02;
Active layer 133:
Barrier layer 133a: undoped GaN, growth temperature: 840°C, thickness: 15 nanometers;
Well layer 133b: undoped InGaN, growth temperature: 840°C, thickness: 3 nanometers, indium composition: 0.08;
Waveguiding layer 134b: undoped InGaN, growth temperature: 840°C, thickness: 65 nanometers, indium composition: 0.02;
Waveguiding layer 134a: undoped GaN, growth temperature: 840°C, thickness: 50 nanometers;
Electron blocking layer 135: Mg-doped AlGaN, growth temperature: 1000°C, thickness: 20 nanometers, aluminum composition: 0.12;
P-type cladding layer 136: Mg-doped AlGaN, growth temperature: 1000°C, thickness: 400 nanometers, aluminum composition: 0.06;
P-type contact layer 137: Mg-doped GaN, growth temperature: 1000°C, thickness: 50 nanometers.

An insulating layer 138, such as silicon oxide, is grown on the p-type contact layer 137, and a stripe window of 10 micrometer wide is formed using photolithography and wet-etching. A p-electrode (Ni/Au) 139a is formed thereon and is contact with the p-type contact layer 137 through the stripe window, and then a pad electrode (Ti/Au) is formed thereon by evaporation. An n-electrode (Ni/Al) 139b is formed on the back side of the GaN substrate 130, and then a pad electrode (Ti/Au) is formed thereon by evaporation. These steps complete a substrate product, and the substrate product is cleaved at 800 micrometer intervals to form a-plane cleavage surfaces.

The above laser diode has a lasing wavelength of 405 nanometers. Its threshold current is 9 kA/cm² and the operating voltage is 5.8 volts (at current of 720 mA).

A GaN substrate having a (20-21) plane (m-plane +75 degree off GaN substrate) and a GaN substrate having a (20-2-1) plane (m-plane -75 degree off GaN substrate) are placed on the susceptor of the reactor. A semiconductor laminate for a light emitting device is grown on each of these GaN substrates in the same run. Their active layers have a quantum well structure, which include a barrier layer of GaN and a well layer of InGaN. The active layers are grown at a temperature of 800°C.

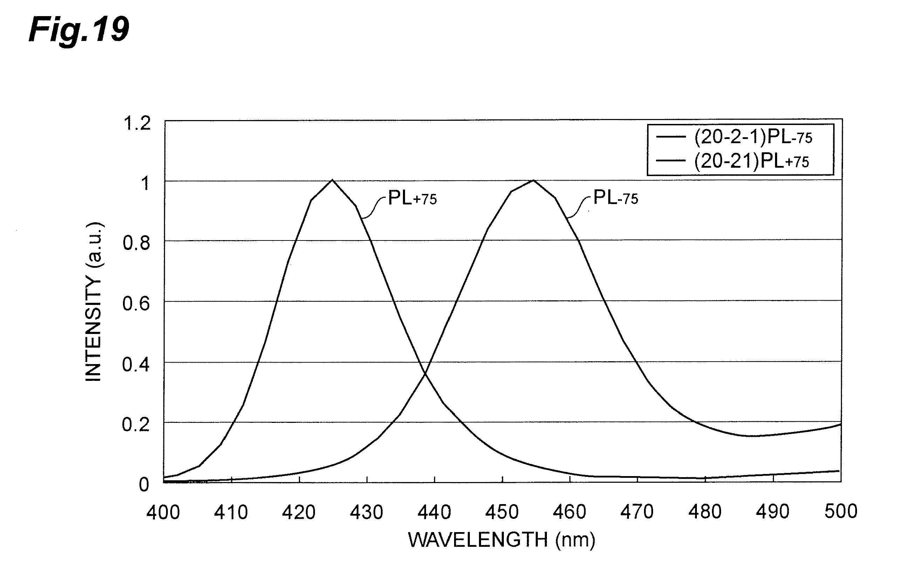

Fig. 19 is a graph showing a photoluminescence (PL) spectrum PL₊₇₅ of a quantum well structure formed on an m-plane +75 degree off GaN substrate, and a photoluminescence (PL) spectrum PL₋₇₅ of a quantum well structure formed on an m-plane -75 degree off GaN substrate. The peak wavelength of the photoluminescence (PL) spectrum PL₊₇₅ is 424 nanometers, whereas the peak wavelength of the photoluminescence (PL) spectrum PL₋₇₅ is 455 nanometers. The difference between the peak wavelength values is about 30 nanometers, which shows that the indium incorporation of the (20-2-1) plane tilting with respect to the N-plane is greater than that of the (20-21) plane tilting with respect to the Ga-plane. When the normal axis of the primary surface tilts toward the m-axis direction at an angle in the range of 63 degrees or more and less than 80 degrees with respect to the [000-1] axis that is defined as the reference axis Cx in Fig. 1, the primary surface has high indium incorporation capacity.

In the above embodiment, the normal axis of the primary surface tilts at an angle in the range of 63 degrees or more and less than 80 degrees with respect to one of the [000-1] and [0001] axes. This tilting does not allow the cleavage of the m-plane and does allow the cleavage of the a-plane. The epitaxial laminate structures for semiconductor lasers have been formed on the semi-polar surface that tilts at an acute angle with respect to the (0001) plane. These epitaxial laminate structures for semiconductor lasers are formed on the primary surfaces of GaN substrates (for example, the (20-21) plane) the normal axis of which tilts at an angle in the range of 63 degrees or more and less than 80 degrees with respect to the [0001] axis. According to the inventors' knowledge, yield of a-plane cleavage is lower than that of m-plane cleavage.

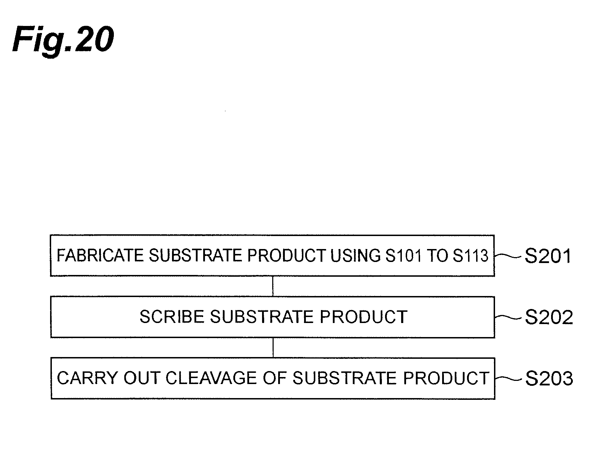

Fig. 20 is a flow chart showing major steps in a method of fabricating a semiconductor light emitting using a substrate having a semi-polar surface tilting at an acute angle with respect to the (000-1) plane. In the step S201, the steps S101 to 113 which have already been explained above can be carried out to fabricate a substrate product 141. The substrate product 141 has a primary surface 141 a and a back surface 141b. In the following explanation, the substrate product 141 includes an epitaxial laminate structure for a semiconductor laser formed on the surface that tilts with respect to the (000-1) plane at an angle in the range of 63 degrees or more and less than 80 degrees. To facilitate the understanding, a dashed box in part (a) of Fig. 12 indicates the laminate structure ELS in Example 8. In the schematic view in part (a) of Fig. 12, the contact window extends in the a-axis direction, and the electrode 139a also extends in the a-axis direction. The substrate product 141 includes, for example, the GaN substrate 130 having the primary surface of the (20-2-1) plane.

In step 202 in Fig. 20, the primary surface 141a of the substrate product 141 is scribed in the direction of the m-axis of the GaN substrate 130. The scribing is carried out with a scriber 143. The scriber 143 can form scribe marks 145 at the edge of the surface 141a. The interval of the scribe marks 145 is associated with the length of the laser cavity. Each of the scribe marks 145 extends in the direction of the intersection defined by the surface 141a and the plane that is defined by the c-axis and the m-axis of the GaN substrate 130.

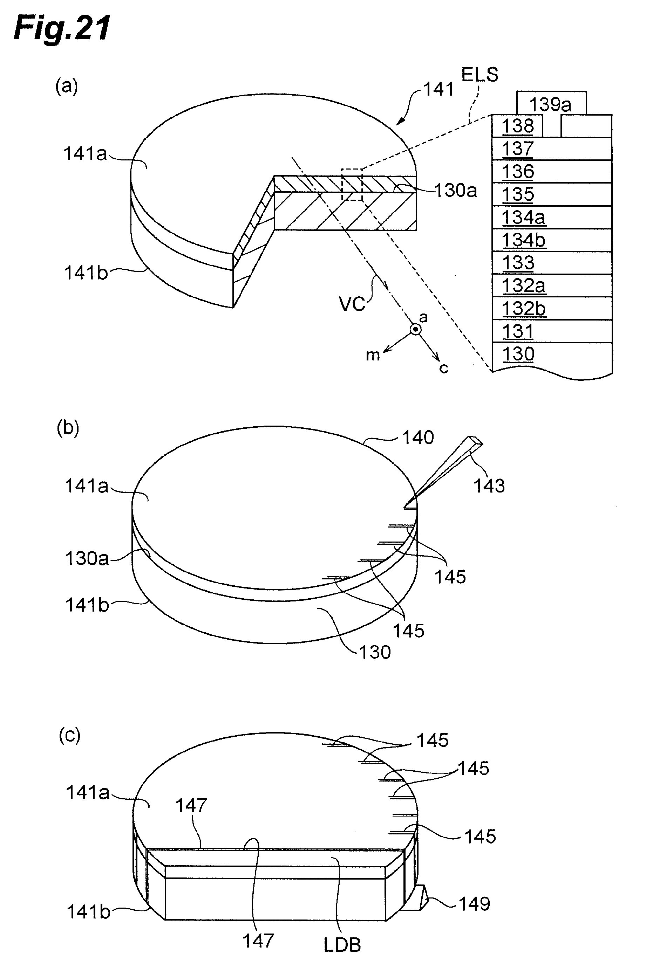

In step 203 in Fig. 20, after scribing the substrate product 141, the substrate product 141 is cleaved to form a cleavage plane 147 as shown in part (c) of Fig. 21. This cleavage plane 147 includes the a-plane. The scribing can be carried out by pressing the substrate product 141 with a pressing tool 149, such as blade. After aligning the pressing tool 149 with one of the scribe marks 145 along which the substrate product 141 is cleaved, the back side 141b of the substrate product 141 is pressed with the pressing tool 149. Choosing the scribe mark 145 permits the control of the position that the cleavage propagates. Since the semiconductor laminate (131 to 137) is epitaxially grown on the primary surface 13a of the GaN substrate 130, the cleavage can form a laser bar LDB having cleavage planes that are aligned with the direction of the scribe marks 145 on the backside of the substrate.

The present method scribes the surface 141a of the substrate product 141 fabricated by forming epitaxial layers on the primary surface that tilts with respect to the [000-1] axis at an angle in the range of 63 degrees or more and less than 80 degrees. This scribing method provides excellent yield of the cleavage. As explained above, choosing the reference axis in the direction of the [000-1] axis reduces the decease in the optical characteristics.

### (Example 9)

The substrate product 141 is cleaved along a scribe groove formed in the surface 141a thereof to form a laser bar (hereinafter referred to as "-scribe"). The substrate product E5 is cleaved along a scribe groove formed in the surface E5 thereof to form a laser bar (hereinafter referred to as "+scribe"). The inventors' experiments show that the yield of the "-scribe" is 1.4 times as well as the yield of the "+scribe." The method of the "-scribe" provides excellent scribe yield.

### (Example 10)

Epitaxial growth is carried out on (20-21) surfaces of GaN wafers to prepare two epitaxial wafers. One of the two epitaxial wafers is scribed along its topside, and the scribed epitaxial wafer is cleaved to form a laser bar ("+scribe"). The other of the two epitaxial wafers is scribed along its backside, and the scribed epitaxial wafer is cleaved to form a laser bar ("-scribe"). The yield of the back side cleavage as "-scribe" is 1.4 times as well as the yield of the front side cleavage as the +scribe.

In the GaN wafer having a primary surface of the (20-21) plane, a GaN based epitaxial region is grown on the primary surface to form an epitaxial wafer, and a substrate product is formed from the epitaxial wafer. In the substrate product formed by using the (20-21) primary surface of the GaN wafer, it is preferable that the backside of the substrate product (the backside of the wafer) be scribed. This is to form scribe marks on the (20-2-1) plane. The (20-2-1) plane of GaN is composed of Ga-plane, whereas the (20-21) plane of GaN is composed of N-plane. The (20-2-1) plane is harder than the (20-21) plane in hardness. Scribing the backside of the wafer, i.e. (20-2-1) plane, enhances the yield of cleavage.

Growth of GaN based semiconductor is explained below.

### 1. Growth mechanism of GaN and InGaN (Stable Plane)

Growth mechanism of GaN and InGaN is explained below. In the growth of GaN based semiconductor, a crystal plane orientation, for example, c-plane, has a growth surface, which is flat at the atomic level, formed during its growth, and this crystal plane orientation is called as "stable plane." Growth mechanism of GaN onto the stable plane is as follows. In the growth of GaN growth onto the stable plane, macroscopic atomic-level steps, having terraces of large width such as a few hundred nanometers, is formed. The growth of GaN based semiconductor is categorized into three groups in view of the growth temperature.

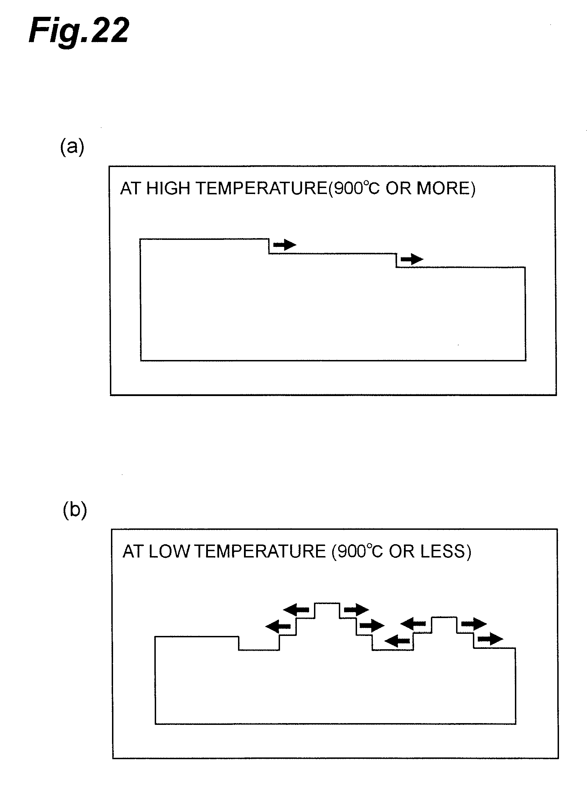

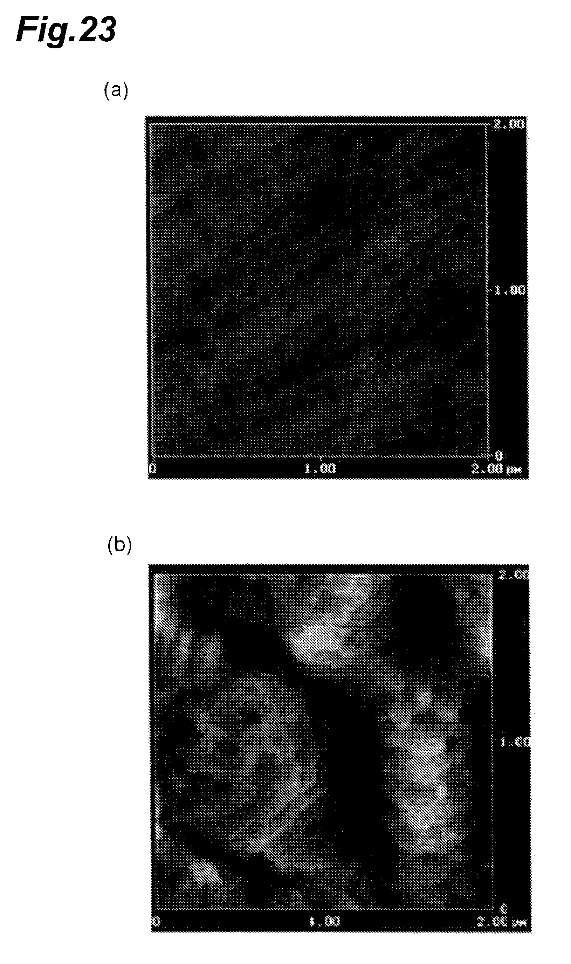

Fig. 22 is a schematic view showing growth modes in high and low temperatures. Part (a) of Fig. 22 shows a growth mode observed in the range of temperature exceeding 900°C of the reactor. In the high temperature, since long-range migration of GaN molecules is allowed on the growth surface, most of the GaN molecules are rarely incorporated, and the GaN molecules move to step edges, called as "kink," having a large activation energy and are incorporated thereat to form crystal. In this growth mode, crystal grows at the step edges by stacking to form crystal. The growth mode is called as "step flow like growth." Fig. 23 is a view showing AFM images of GaN growth surfaces. Part (a) of Fig. 23 shows the arrangement of atomic layer steps in one direction.

In the range of the growth temperature of 900°C to 700°C, the growth mode as shown in Part (b) of Fig. 22 is observed. In the low temperature, since the migration range of the molecules is short on the growth surface, most of the molecules are incorporated in the wide terraces to form crystal before they move to step edges. In this growth mode, incorporation of the molecules forms nucleuses for growth, and steps grow from the nucleuses to form crystal. The growth mode is called as "on-terrace growth." Part (a) of Fig. 23 shows an AFM image of the GaN growth surface. In view of the surface morphology, this growth forms many nucleuses and grows steps from these nucleuses. Accordingly, the atomic layer steps grow in all direction, not one direction.

In the growth temperature range of 700°C or lower, growth mechanism different from the above growth modes is observed. Since the migration of the molecules rarely occurs on the growth surface, the GaN molecules are incorporated without migration to form crystal when they reach the growth surface.
In this growth mode, crystal defects are easily formed into the crystal, and the growth mode does not provide GaN films with high quality. The growth mode is called as "island-like growth."

Next, crystal growth on crystal planes of various orientations that tilt toward the m-axis direction with respect to the c-axis direction is explained below. GaN films are grown at a temperature of 1100°C on the crystal planes of various orientations that tilt toward the m-axis direction with respect to the c-axis direction. The surfaces of these GaN films are observed, and this observation reveals that the crystal orientations that have macroscopic atomic-level steps as shown in Part (a) of Fig. 22 are the only three constituent planes as follows: the c-plane; the m-plane; and the {10-11} planes tilting at an angle of about 62 degrees. That is, in the growth in the crystal plane tilting toward the m-axis direction with respect to the c-plane, the stable planes encompass the only three planes as above. Other crystal planes, which are different from the above three planes, are called as "Unstable Plane."

Next, growth mechanism of InGaN onto the stable planes is explained below. The growth mechanism of InGaN is almost the same as that of GaN except for the following. The difference is as follows: in the InGaN growth, the staying time for InN is shorter than that of GaN, and the desorption of InN molecules easily occurs. This indicates that, in order to grow an increased indium composition of InGaN, the growth temperature of the InGaN should be decreased and that the growth temperature is in the range of 900°C or less. That is, InGaN growth on the stable planes is categorized into "on-terrace growth."

### 2. Growth mechanism of GaN and InGaN (Unstable Plane)

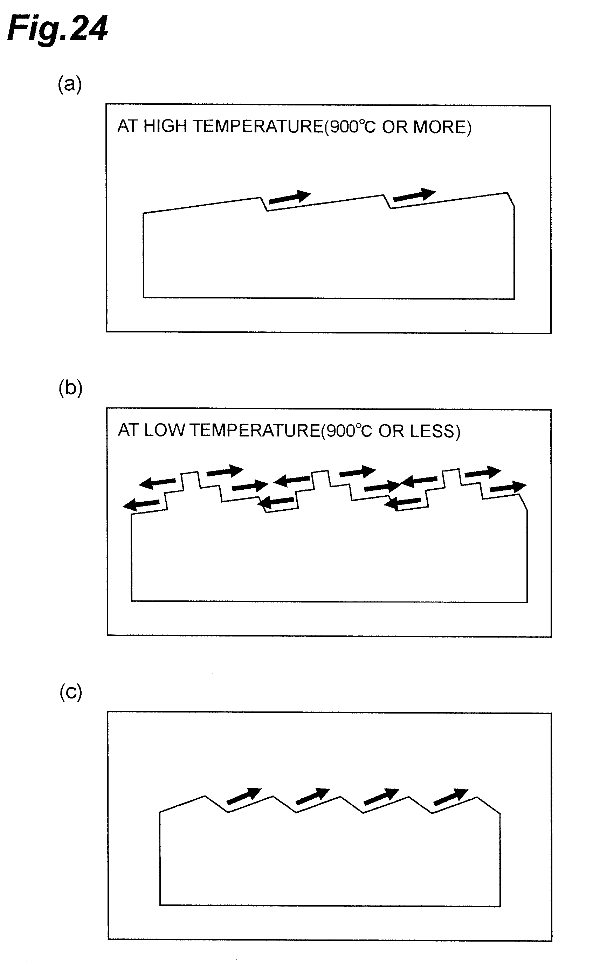

Growth mechanism of GaN and InGaN onto the unstable planes is explained below. The observation of AFM images of GaN surfaces grown on an unstable plane at a temperature of 1100°C reveal that fine steps are formed on a surface tilting at a small angle (referred to as "sub-off angle") with respect to the nearest stable plane and that the fine steps are composed of stable planes near the off angle. The terrace width is smaller than that of the growth onto the just stable plane, and is reduced as the sub-off angle is increased. In the tilt angle of about 2 degrees with respect to the stable plane, the AFM image does not show any atomic level steps. Accordingly, growth onto a surface near a stable plane easily forms stable planes. Part (a) of Fig. 24 is a schematic view showing growth mechanism of step flow like growth of GaN and InGaN on a non-stable plane at high temperature. The arrow indicates the growth direction.

On the contrary, in the growth onto a surface tilting at a large angle with respect to a stable plane, the width of terraces is made small and the microscopic steps smaller than the observable limit by AFM may be formed. Since the stable planes encompass the above three orientations, the above microscopic steps may be composed of the stable planes and may extend in a certain direction in the GaN surface formed at a high temperature.

Growth mechanism of GaN grown at a low temperature is explained below. In the growth onto a surface near a stable plane, the width of terraces is large and the terraces are composed of the stable planes. Since migration of the molecules is short, the major growth mechanism is on-terrace growth. Part (b) of Fig. 24 is a schematic view showing growth mechanism of on-terrace growth of GaN and InGaN on a non-stable plane at low temperature.

In the growth onto the crystal plane having a large sub-off angle with respect to the stable plane, the density of surface steps is high, and the width of the terraces has a microscopic size, such as a few nanometers. When the sub-off angle with respect to the stable angle is large, the narrow terrace width prevents the growth mode of on-terrace growth. Even at a growth temperature at which the migration of the molecules is short on the growth surface, atoms can reach step edges that have high activation energy. That is, when the sub-off angle is large with respect to the stable plane, the growth mode is as follows: the step edges grow even at a low temperature. Since the terrace width is two orders of magnitude smaller as compared with the step flow growth, this growth mode is referred to as "step edge growth." Part (c) of Fig. 24 shows growth mechanism of step edge growth of GaN and InGaN on a non-stable face at low temperature.

The summary is as follows. In the low temperature growth, the on-terrace growth is dominant in the growth onto a stable plane or near a stable plane. As the sub-off angle is increased with respect to a stable plane, the dominant growth mode gradually changes from the on-terrace growth to the step-edge growth. This growth mode behavior is consistent with InGaN growth mechanism at a low temperature.

### 3. Indium Incorporation

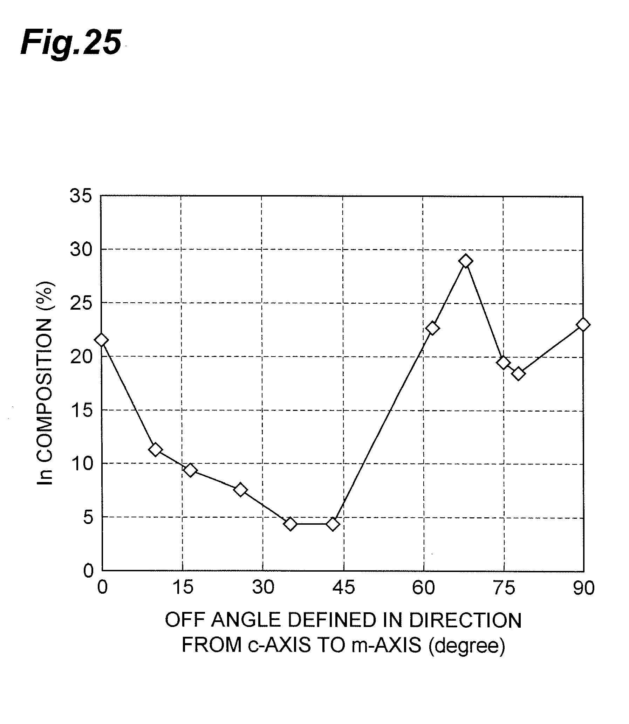

Indium incorporation in InGaN growth onto various growth surfaces is explained below. Experiments in which InGaN is grown in the same condition at a temperature of 760°C are conducted. Fig. 25 is a graph showing the result of the experiments, the axis of abscissas indicates a tilt angle from the c-axis toward the m-axis direction (off angle), and the axis of ordinate indicates the indium composition of InGaN.

| Tilt angle, | In composition, |
|---|---|
| 0, | 21.6; |
| 10, | 11.2; |
| 16.6, | 9.36; |
| 25.9, | 7.54; |
| 35, | 4.33; |
| 43, | 4.34; |
| 62, | 22.7; |
| 68, | 29; |
| 75, | 19.6; |
| 78, | 18.5; |
| 90, | 23.1. |

Referring to Fig. 25, indium incorporation in the c-plane is excellent. As an off angle is increased from the c-plane, the indium incorporation is reduced. As the off angle is further increased, the indium incorporation starts to increase in a tilt angle range of around 40 degrees or more. The indium incorporation in the {10-11} plane of the stable plane is nearly equal to the indium incorporation in the c-plane. As the off angle is further increased, the indium incorporation is improved and reaches a maximum at an angle of around 68 degrees. When the off angle exceeds this angle, the indium incorporation starts to decrease. The indium incorporation reaches a minimum at an angle of around 80 degrees. When the off angle exceeds this angle toward the m-plane, the indium incorporation is again improved. The indium incorporation in the m-plane is nearly equal to the indium incorporation in the c-plane.

Behavior of the indium incorporation is explained based on the indium incorporation in the above items 1 and 2.

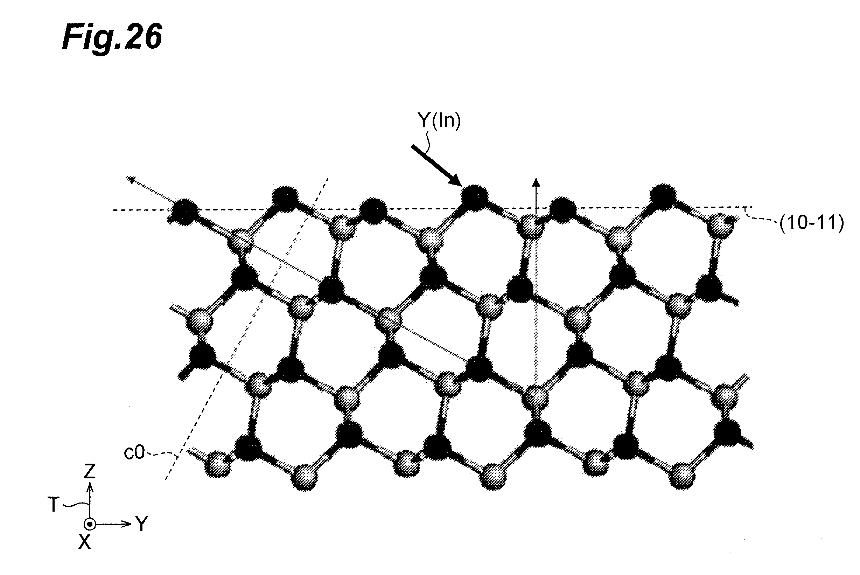

When the on-terrace growth is dominant around the stable plane as shown in Part (b) of Fig. 22, indium incorporation is improved as shown in Fig. 25. The reason why the terraces of the stable planes have strong indium incorporation can be explained with reference to the arrangement of atoms in a crystal surface as follows. Fig. 26 shows the arrangement of surface atoms of {10-11} plane as an example. Referring to Fig. 26, the c-plane c0 and the (10-11) plane are shown. As shown in Fig. 26, an indium atom bonds two nitrogen atoms through two chemical hands indicated by Arrow Y(In). The two nitrogen atoms are arranged in the X-axis direction in the orthogonal coordinate system "T" in Fig. 26. The two nitrogen atoms can be displaced toward the positive X-direction (front side) and the negative X-direction (far side), and this atomic arrangement facilitates incorporation of indium having a large radius. This arrangement can explain the facilitation of indium incorporation in the on-terrace growth.

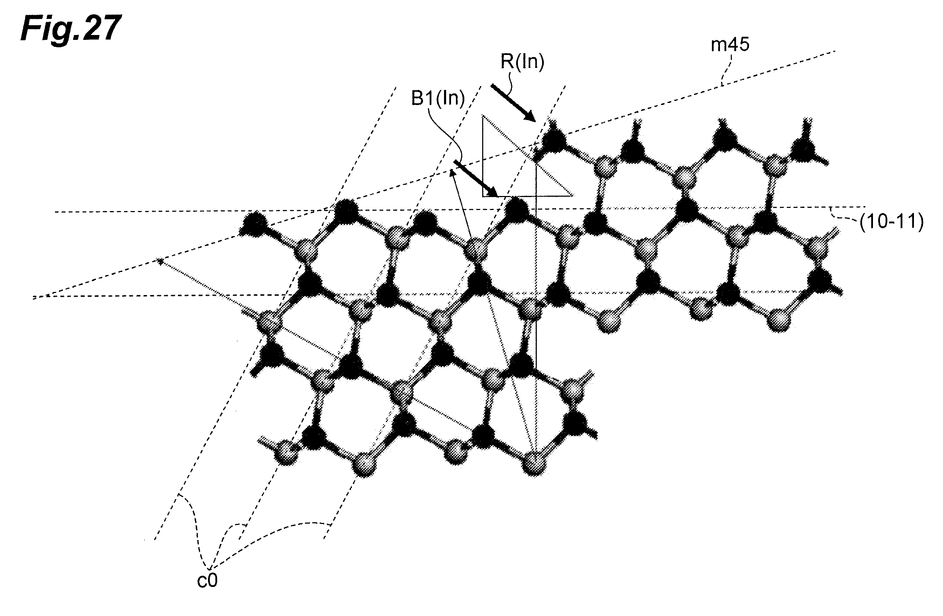

Indium incorporation in the step edge growth is explained below in the same manner. Fig. 27 shows the arrangement of surface atoms at a surface tilting at an angle of 45 degrees toward the m-axis direction as an example. Referring to Fig. 27, the c-plane C0, a tilt surface m45 tilting from the c-plane at an angle of 45 degrees, and the (10-11) plane are shown. When focusing on the step edges, an indium atom bonds two nitrogen atoms through two chemical hands indicated by Arrow B1(In), and bonds one nitrogen atom through one chemical hand indicated by Arrow R(In). The displacement direction of the nitrogen atom indicated by Arrow R(In) is perpendicular to that of the nitrogen atoms indicated by Arrow B1(In), associated with bonds to indium atoms, and the three nitrogen atoms should move in order to incorporate an indium atom having a large radius. This atomic arrangement does not facilitate incorporation of indium. This shows that the indium incorporation in the on-terrace growth is low in the steps edge growth. This explanation is consistent with a part of the result in Fig. 25. That is, the on-terrace growth is dominant around the stable planes and exhibits excellent indium incorporation. As the sub-off angle with reference to the stable plane is increased, the dominant growth mode changes from the on-terrace growth to the step edge growth to reduce the indium incorporation.

The above explanation can be applied to the growth mode in the angle range between the {10-11} plane and the m-plane.

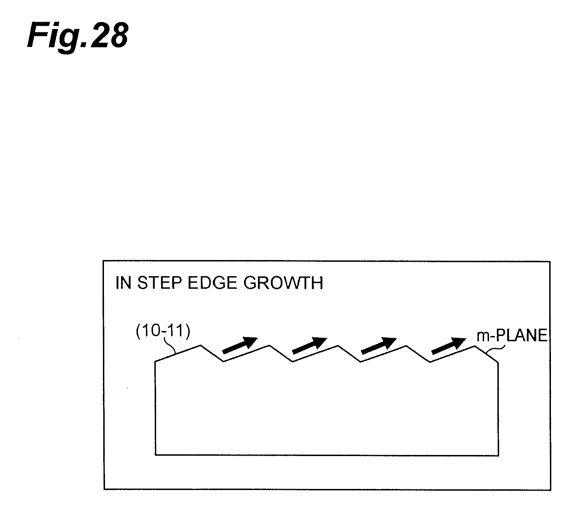

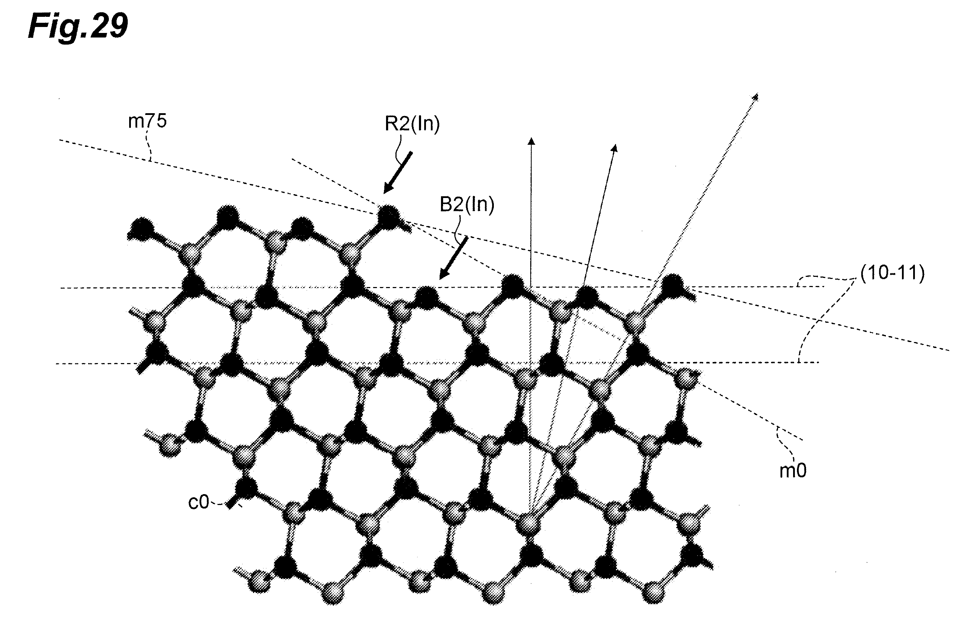

However, the above explanation cannot be applied to a growth mode in the off angle range of 63 degrees or more and less than 80 degrees with respect to the c-plane, which is near the {10-10} plane in the angle range between the {10-11} plane and the m-plane. The surface atomic arrangement in this angle range is further researched. The inventors' research finds that step edges in the above angle have high indium incorporation. Fig. 28 shows an example of plural steps in the surface that tilts toward the m-axis direction at an angle of 75 degrees. In this angle range, as shown in Fig. 28, the surface in this angle range has micro-steps composed of the {10-11} plane and the m-plane. Steps edge growth occurs such that the step-edges grow in the m-axis direction. Fig. 29 shows the arrangement of surface atoms in a surface formed by tilting the c-plane at an angle of 75 degrees toward the m-axis direction as an example. Referring to Fig. 29, the m-plane m0, a tilt surface m75 tilting from the c-plane at an angle of 75 degrees, and the (10-11) plane are shown. In this case, an indium atom to be incorporated bonds one nitrogen atom through one chemical hand indicated by Arrow R1(In), and bonds one nitrogen atom through one chemical hand indicated by Arrow B2(In). In this arrangement, the displacement directions of these two indium atoms are opposite to each other, and the only two nitrogen atoms should move in order to incorporate an indium atom having a large radius. This facilitates the indium incorporation at the steps edges. The inventors have research atomic arrangements at step edges in another angle range, and the only above angle range allows steps edge growth having excellent indium incorporation.

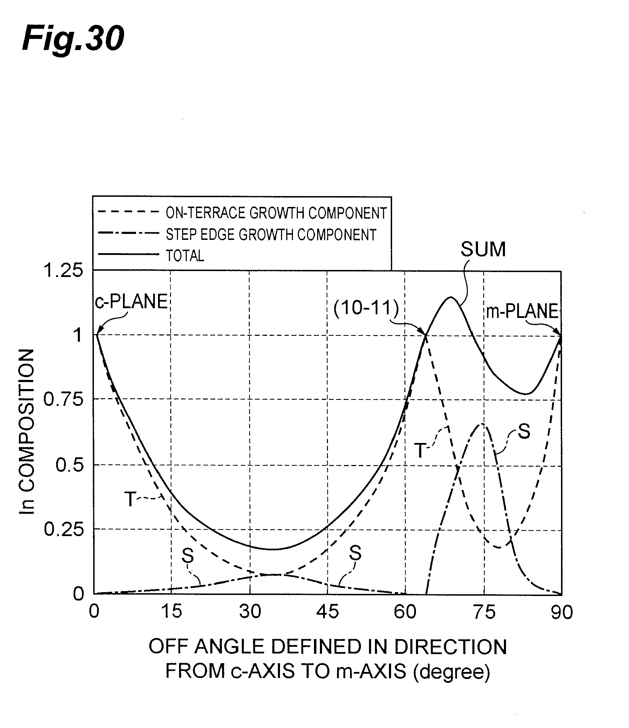

The inventors estimate an off angle dependency of indium incorporation based on the above researches. Fig. 30 shows the relationship between indium incorporation and the off angle. In order to obtain the total indium incorporation, the step edge growth component and the on-terrace growth component are estimated and these components are summed. The axis of coordinate indicates indium incorporation normalized by the indium incorporation on the c-plane. The solid line "T" shows quantity of indium incorporated in the on-terrace growth; the solid line "S" shows quantity of indium incorporated in the steps edge growth; and the solid line "SUM" shows the sum of the above two components. As shown above, regarding the on-terrace growth, the indium incorporation is high around the stable planes in which the on-terrace growth is dominant, and the on-terrace growth does not become dominant as the tilt angle of the growth surface from the stable planes is increased, so that the indium incorporation is reduced.

The step-edge growth is dominant because the density of the steps is increased as the growth surface tilts from the stable planes. But, little indium incorporation in the step-edge growth occurs outside the angle range of 63 degrees or more and less than 80 degrees. Since high indium incorporation occurs in the step edge growth only in the angle range of 63 degrees or more and less than 80 degrees, the indium incorporation is increased as the step-edge growth is activated. The resultant growth shows the off-angle dependency as indicated by the solid line SUM, and the estimation in the step edge growth in Fig. 30 is excellent agreement with the experimental result shown in Fig. 25.

4. Indium segregation in InGaN is explained below in consideration of the above explanation on indium segregation. The optical device including an InGaN active layer on the c-plane substrate has high indium segregation as the wavelength of the active layer is increased, i.e., indium composition of the InGaN crystal is increased. The high indium segregation reduces crystal quality of the InGaN, thereby reducing the optical intensity and broadening the full width at half maximum. The inventor' experimental results in the range of a tilt angle of 63 degrees or more and less than 80 degrees toward the m-axis direction show as follows: the reduction in the optical intensity is small and broadening of the full width at half maximum is also small when compared with InGaN layers on the c-plane and the other stable planes.

The inventors have studied the reasons for the above observations in view of growth mechanism and indium incorporation. The reason why InGaN films grown on the stable planes have high indium segregation is as follows. As shown in Part (b) of Fig. 22, GaN and InN molecules can migrate on wide terraces after reaching the terraces and prior to incorporation of the molecules into the crystal. During the migration, InN molecules spontaneously aggregate because of immiscibility of GaN and InN. This aggregation is associated with the indium segregation.

As shown in Fig. 30, when the surface has a large sub-off angle with respect to the stable surface, indium atoms are incorporated into the crystal at step edges. GaN and InN molecules are incorporated into the crystal just after these molecules reach the growth surface without their migration. Indium atoms incorporated as above become randomly-distributed, resulting in a uniform InGaN film. This phenomenon is pronounced as the steps density increases. Accordingly, a uniform InGaN film grows on a surface as the sub-off-angle of the surface increases. However, as already explained above, indium incorporation is small in the step edge growth at a tilt angle except the particular angle range, so that the growth temperature should be decreased in order to obtain a desired indium composition. But, lowering the growth temperature changes the dominant growth mode from the steps edge growth to the island-like growth, resulting in considerably poor crystal quality of the InGaN due to increase in crystal defects.

As explained above, trade-off is likely to be between the indium incorporation and the indium segregation. The inventors have found a solution of a tilt angle to the incompatibility between the indium incorporation and the indium segregation. The tilt angle is in the range of 63 degrees or more and less than 80 degrees. The growth onto a surface at a tilt angle in the above range permits small indium segregation and effective indium incorporation even in the step edge growth mode. Especially in the growth onto a surface at a tilt angle in the range of 70 degrees or more and less than 80 degrees, the surface has a high step density, which permits the growth of InGaN films with small indium segregation and high uniformity. Further, taking indium incorporation into consideration, the tilt angle range of 71 degrees or more and 79 degrees or less strikes a balance between the step edge growth and the on-terrace growth. Furthermore, the tilt angle range of 72 degrees or more and 78 degrees or less strikes an optimum balance between the step edge growth and the on-terrace growth. Accordingly, a higher growth temperature can be used to grow an InGaN film having a desired indium composition, and a uniform InGaN film with small defects can be grown.

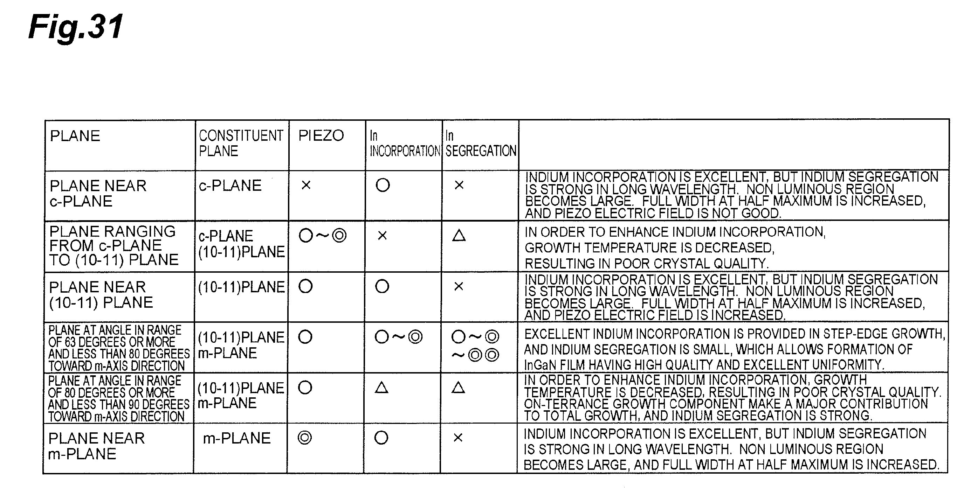

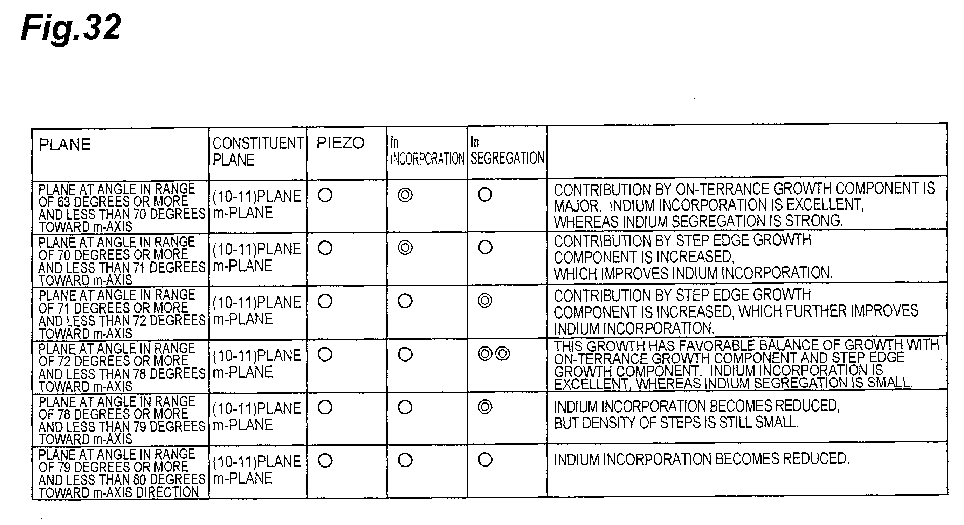

Figs. 31 and 32 are tables showing surface, off angle ranges and feature therein in properties, such as indium incorporation as explained above, indium segregation, and piezo electric field. In Figs. 31 and 32, symbol "double circle" indicates that the property is excellent; symbol "single circle" indicates that the property is better; symbol "triangle" indicates that the property is good; and symbol "cross" indicates that the property is poor. The tables contain the following distinguishing angles defined toward the m-axis direction with respect to the c-axis direction: 63 degrees; 70 degrees; 71 degrees; 72 degrees; 78 degrees; 79 degrees and 80 degrees. The angle range of 63 degrees or more and less than 80 degrees is better; the angle range of 70 degrees or more and less than 80 degrees is much better; the angle range of 71 degrees or more and 79 degrees or less is more appropriate; the angle range of 72 degrees or more and 78 degrees or less is the most appropriate to fabricate long wavelength emission devices, such as light emitting diodes and laser diodes, thereby providing high optical intensity and narrow full width at half maximum.

In the above explanations, notations, such as (20-21) and (10-11), are used. Taking the description in the present embodiments into consideration, those skilled in the art thinks that crystal planes crystallographically equivalent thereto has the same or similar advantages. Accordingly, for example, the crystal plane referred to as "(20-21)" encompasses the following equivalent planes: (2-201); (-2201); (20-21); (-2021); (02-21); (0-221).

Having described and illustrated the principle of the invention in a preferred embodiment thereof, it is appreciated by those having skill in the art that the invention can be modified in arrangement and detail without departing from such principles. We therefore claim all modifications and variations coming within the spirit and scope of the following claims.

Recently, there is a demand for long wavelength emission in GaN based light emitting devices, and attention is particularly focused on semi-polar surfaces tilting from the c-plane, and non-polar surfaces such as the m-plane and the a-plane. The reason is as follows. Since the indium composition is increased in order to have a long wavelength emission, the difference in the lattice constant between the well layer and the barrier layer is also increased, resulting in incorporation of increased strain into the active layer. The increased strain reduces quantum efficiency due to piezo electric field in the polar surface such as the c-plane. In order to prevent the reduction in quantum efficiency, studies of various crystal planes, such as non-polar surface (m-plane and a-plane) are being carried out. But, nobody has developed an optical device having an optical efficiency greater than that on the c-plane. The inventors have focus on the plane that has a tilt angle in the range of 63 degrees or more and less than 80 degrees toward the m-axis direction with respect to the c-plane, in order to form a micro step structure composed of the m-plane and the (10-11) plane tilting at an angle of about 62 degrees toward the m-axis direction with respect to the c-plane. Further, the inventors have particularly focus on the (20-21) plane that has a tilt angle of 75 degrees toward the m-axis direction with respect to the c-plane, and the plane that has a tilt angle in the range of 63 degrees or more and less than 80 degrees, containing the (20-21) plane, toward the m-axis direction with respect to the c-plane, and furthermore in the range of 70 degrees or more and less than 80 degrees toward the m-axis direction with respect to the c-plane. In the above angle ranges, the terrace width of the (10-11) plane and the terrace width of the m-plane in the substrate primary surface both are small, and the step density of the substrate primary surface is large, resulting in reduced indium segregation.

### Reference Signs List

11a, 11b: GaN based semiconductor optical device;
VN: normal vector;
CV+: [0001] axis direction vector;
CV-: [000-1] axis direction vector;
Sc: reference plane:
Cx: reference axis:
Ax: predetermined axis:
13: substrate:
13a: primary surface of substrate:
15: GaN based semiconductor epitaxial region;
17: active layer;
α: tilt angle of primary surface;
19: semiconductor epitaxial layer;
M1, M2, M3: surface morphology;
21: GaN based semiconductor region;
23: n-type GaN semiconductor layer;
25: n-type InGaN semiconductor layer;
27: electron blocking layer;
29: contact layer;
31: quantum well structure:
33 well layer;
35 barrier layer:;
37 first electrode;
39: second electrode;
A_{OFF}: a-axis direction off angle;
41: n-type cladding layer;
43a: waveguiding layer;
43b: waveguiding layer;
45: electron blocking layer;
47: cladding layer;
49: contact layer;
51 first electrode;
53: insulating film;
55: second electrode;
141: substrate product;
141a: primary surface of substrate product;
141b: backside surface of substrate product;
143: scriber;
145: scribe mark;
147: cleavage plane;
149: pressing tool;
LDB: laser bar.

## Claims

1. A GaN based semiconductor optical device comprising:
a substrate composed of a first GaN based semiconductor, the substrate having a primary surface, the primary surface tilting at an angle toward an m-axis direction of the first GaN based semiconductor with respect to a plane perpendicular to a reference axis, the reference axis extending in a direction of a c-axis of the first GaN based semiconductor, the angle being 63 degrees or more, and the angle being less than 80 degrees;
a GaN based semiconductor epitaxial region provided on the primary surface; and
a semiconductor epitaxial layer for an active layer, the semiconductor epitaxial layer being provided on the GaN based semiconductor epitaxial region,
the semiconductor epitaxial layer being composed of a second GaN based semiconductor, the second GaN based semiconductor comprising indium, and a c-axis of the semiconductor epitaxial layer tilting with respect to the reference axis,
the reference axis being directed to one of [0001] and [000-1] axes of the first GaN based semiconductor.

2. The GaN based semiconductor optical device according to claim 1, wherein the primary surface of the substrate tilts toward the m-axis direction of the first GaN based semiconductor at an angle of 70 degrees or more with respect to the plane perpendicular to the reference axis.

3. The GaN based semiconductor optical device according to claim 1 or 2, wherein the primary surface of the substrate tilts toward the m-axis direction of the first GaN based semiconductor at an angle of 71 degrees to 79 degrees with respect to the plane perpendicular to the reference axis.

4. The GaN based semiconductor optical device according to any one of claims 1 to 3, wherein an off angle toward the a-axis of the first GaN based semiconductor is not zero, and the off angle is -3 degrees or more and +3 degrees or less.

5. The GaN based semiconductor optical device according to any one of claims 1 to 4, further comprising a second conductive type GaN based semiconductor layer provided on the active layer,
wherein the GaN based semiconductor epitaxial region includes a first conductive type GaN based semiconductor layer,
the active layer includes a well layer and a barrier layer arranged in a direction of a predetermined axis,
the well layer is composed of the semiconductor epitaxial layer and the barrier layer is composed of a GaN based semiconductor,
the first conductive type GaN based semiconductor layer, the active layer and the second conductive type GaN based semiconductor layer are arranged in the predetermined axis, and
the direction of the reference axis is different from that of the predetermined axis.

6. The GaN based semiconductor optical device according to any one of claims 1 to 5, wherein the active layer is provided to emit light and a wavelength of the light is in a range of 370 nanometers to 650 nanometers.

7. The GaN based semiconductor optical device according to any one of claims 1 to 6, wherein the active layer is provided to emit light and a wavelength of the light is in a range of 480 nanometers to 600 nanometers.

8. The GaN based semiconductor optical device according to any one of claims 1 to 7, wherein the primary surface of the substrate tilts in a range of -3 degrees to +3 degrees with respect to one of (20-21) and (20-2-1) planes.

9. The GaN based semiconductor optical device according to any one of claims 1 to 8, wherein the reference axis is directed to the [0001] axis.

10. The GaN based semiconductor optical device according to any one of claims 1 to 9, wherein the reference axis is directed to the [000-1] axis.

11. The GaN based semiconductor optical device according to any one of claims 1 to 10, wherein the substrate comprises GaN.

12. The GaN based semiconductor optical device according to any one of claims 1 to 11, wherein surface morphology of the surface of the substrate has plural micro-steps, and major constituent planes of the plural micro-steps include at least m-plane and (10-11) plane.

13. A method of fabricating a GaN based semiconductor optical device, comprising the steps of:
performing thermal treatment of a wafer, the wafer being composed of a first GaN based semiconductor, a primary surface of the wafer tilting at an angle toward an m-axis direction of the first GaN based semiconductor with respect to a plane perpendicular to a reference axis, the reference axis extending in a direction of a c-axis of the first GaN based semiconductor, the angle being 63 degrees or more, and the angle being less than 80 degrees;
growing a GaN based semiconductor epitaxial region for an active layer on the primary surface;
forming a semiconductor epitaxial layer on a primary surface of the GaN based semiconductor epitaxial region,
the semiconductor epitaxial layer being composed of a second GaN based semiconductor, the second GaN based semiconductor comprising indium as a constituent element, and a c-axis of the semiconductor epitaxial layer tilting with respect to the reference axis, and
the reference axis being directed to one of [0001] and [000-1] axes of the first GaN based semiconductor.

14. The method according to claim 13, wherein the primary surface of the substrate tilts toward the m-axis direction of the first GaN based semiconductor at an angle of 70 degrees or more with respect to the plane perpendicular to the reference axis.

15. The method according to claim 13 or 14, wherein the primary surface of the wafer tilts toward the m-axis direction of the first GaN based semiconductor at an angle of 71 degrees to 79 degrees with respect to the plane perpendicular to the reference axis.

16. The method according to any one of claims 13 to 15, wherein
the active layer includes a quantum well structure, the quantum well structure has a well layer and a barrier layer arranged in a direction of a predetermined axis,
the semiconductor epitaxial layer includes the well layer,
the barrier layer is composed of a GaN based semiconductor,
and
the GaN based semiconductor epitaxial region includes a first conductive type GaN based semiconductor layer,
the method further comprising the steps of:
forming the barrier layer on the semiconductor epitaxial layer; and
growing second conductive type GaN based semiconductor layer on the active layer,
wherein the first conductive type GaN based semiconductor layer, the active layer and the second conductive type GaN based semiconductor layer are arranged in the predetermined axis, and the direction of the reference axis is different from the predetermined axis.

17. The method according to any one of claims 13 to 16, wherein an off angle toward the a-axis direction of the first GaN based semiconductor is not zero, and the off angle is -3 degrees or more and +3 degrees or less.

18. The GaN based semiconductor optical device according to any one of claims 13 to 17, wherein the primary surface of the wafer tilts in a range of -3 degrees to +3 degrees with respect to one of (20-21) and (20-2-1) planes.

19. The GaN based semiconductor optical device according to any one of claims 13 to 18, wherein the wafer comprises In_{S}Al_{T}Ga_{1-S-T}N (0≤S≤1, 0≤T≤1, 0≤S+T<1)

20. The GaN based semiconductor optical device according to any one of claims 13 to 19, wherein the wafer comprises GaN.

21. The GaN based semiconductor optical device according to any one of claims 13 to 20, wherein surface morphology of the surface of the wafer has plural micro-steps, and the plural micro-steps include at least m-plane and (10-11) plane.

22. A method of fabricating an epitaxial wafer for a GaN based semiconductor optical device, comprising the steps of:
performing thermal treatment of a substrate, the substrate being composed of a first GaN based semiconductor, the substrate having a primary surface, the primary surface tilting at an angle toward an m-axis direction of the first GaN based semiconductor with respect to a plane perpendicular to a reference axis, the reference axis extending in a direction of a c-axis of the first GaN based semiconductor, the angle being 63 degrees or more, and the angle being less than 80 degrees;
growing a GaN based semiconductor epitaxial region on the primary surface; and
forming a semiconductor epitaxial layer for an active layer on a primary surface of the GaN based semiconductor epitaxial region,
the semiconductor epitaxial layer being composed of a second GaN based semiconductor, the second GaN based semiconductor comprising indium as a constituent element, and a c-axis of the semiconductor epitaxial layer tilting with respect to the reference axis, and
the reference axis being directed to one of [0001] and [000-1] axes of the first GaN based semiconductor.

23. The method according to claim 22, wherein the primary surface of the wafer tilts toward the m-axis direction of the first GaN based semiconductor at an angle of 71 degrees to 79 degrees with respect to the plane perpendicular to the reference axis.

24. A method of growing a GaN based semiconductor film, comprising the steps of:
forming a GaN based semiconductor region having a primary surface, the primary surface having plural micro-steps, the micro-steps including at least m- and (10-11) planes as constituent planes,
growing a GaN based semiconductor region on the primary surface of the GaN based semiconductor region, the GaN based semiconductor region containing indium as constituent,
the primary surface of the GaN based semiconductor region tilting at an angle toward an m-axis direction of the GaN based semiconductor region with respect to a plane perpendicular to a reference axis, the reference axis extending in a direction of a c-axis of the GaN based semiconductor region, the angle being 63 degrees or more, and the angle being less than 80 degrees.

25. The method according to claim 24, wherein the primary surface of the GaN based semiconductor region tilts toward the m-axis of the GaN based semiconductor region at an angle of 71 degrees to 79 degrees with respect to the plane perpendicular to the reference axis.

26. A method of fabricating a GaN based semiconductor optical device, comprising the steps of:
performing thermal treatment of a wafer, the wafer being composed of a first GaN based semiconductor;
growing a GaN based semiconductor epitaxial region on a primary surface of the wafer, the GaN based semiconductor epitaxial region comprising a first conductive type GaN based semiconductor layer;
growing a semiconductor epitaxial layer for an active layer on a primary surface of the GaN based semiconductor epitaxial region;
growing a second conductive type GaN based semiconductor layer on the active layer to form an epitaxial wafer;
after forming the epitaxial wafer, forming an anode electrode and a cathode electrode for the GaN based semiconductor optical device to form a semiconductor substrate;
scribing a primary surface of the substrate product in a direction of the m-axis of the first GaN based semiconductor; and
after scribing the primary surface, performing cleavage of the substrate product to form a cleavage plane,
the substrate product including a semiconductor laminate, the semiconductor laminate including the GaN based semiconductor epitaxial region, the semiconductor epitaxial layer, and the second conductive type GaN based semiconductor layer,
the semiconductor laminate being provided between the primary surface of the substrate and the primary surface of the wafer,
the cleavage surface including an a-plane,
the primary surface of the wafer tilting at an angle toward an m-axis direction of the first GaN based semiconductor with respect to a plane perpendicular to a reference axis, the reference axis extending in a direction of a c-axis of the first GaN based semiconductor, the angle being 63 degrees or more, and the angle being less than 80 degrees;
the semiconductor epitaxial layer being composed of a second GaN based semiconductor, the second GaN based semiconductor comprising indium as constituent, and a c-axis of the semiconductor epitaxial layer tilting with respect to the reference axis,
a c-axis of the second GaN based semiconductor tilting with respect to the reference axis, and
the reference axis being directed to a [000-1] axis of the first GaN based semiconductor.

27. The method according to claim 26, wherein the primary surface of the wafer tilts toward the m-axis direction of the first GaN based semiconductor at an angle of 71 degrees to 79 degrees with respect to the plane perpendicular to the reference axis.

28. A method of fabricating a GaN based semiconductor optical device, comprising the steps of:
performing thermal treatment of a wafer, the wafer being composed of a first GaN based semiconductor;
growing a GaN based semiconductor epitaxial region on the primary surface of the wafer, the GaN based semiconductor epitaxial region comprising a first conductive type GaN based semiconductor layer;
growing a semiconductor epitaxial layer for an active layer on a primary surface of the GaN based semiconductor epitaxial region;
growing a second conductive type GaN based semiconductor layer on the active layer to form an epitaxial wafer;
after forming the epitaxial wafer, forming an anode electrode and a cathode electrode for the GaN based semiconductor optical device to form a semiconductor substrate;
scribing a backside of the substrate product in a direction of the m-axis of the first GaN based semiconductor, the backside being opposite to the primary surface; and
after scribing the substrate product, performing cleavage of the substrate product to form a cleavage plane,
the substrate product including a semiconductor laminate, the semiconductor laminate including the GaN based semiconductor epitaxial region, the semiconductor epitaxial layer, and the second conductive type GaN based semiconductor layer,
the semiconductor laminate being provided between the primary surface of the substrate and the primary surface of the wafer,
the cleavage surface including an a-plane,
the primary surface of the wafer having a (20-21) plane,
the semiconductor epitaxial layer being composed of a second GaN based semiconductor, and the second GaN based semiconductor comprising indium as constituent, and
a c-axis of the second GaN based semiconductor tilting with respect to a reference axis, the reference axis extending in a direction of a c-axis of the first GaN based semiconductor,
the reference axis being directed to a [0001] axis of the first GaN based semiconductor.
